# EUROPEAN PATENT APPLICATION

(11) **EP 4 418 305 A1**
(43) Date of publication of application: **21.08.2024**
(21) Application number: 24156044.0
(22) Date of filing: 06.02.2024
(51) Int. Cl.: H01L 21/033

(54) **PATTERNING PROCESS**

(30) Priority: 15.02.2023 JP 2023021981
(71) Applicant: SHIN-ETSU CHEMICAL CO., LTD., Tokyo 1000005 (JP)
(72) Inventor: Kobayashi, Naoki, Niigata (JP); Iwamori, Shohei, Niigata (JP); Kori, Daisuke, Niigata (JP); Ishiwata, Kenta, Niigata (JP)
(74) Representative: Sonnenhauser, Thomas Martin

(57) **Abstract**

A patterning process capable of readily and efficiently forming a fine pattern without damaging a substrate is provided. The patterning process includes: forming an organic underlayer film, a tin-containing middle layer film, and an upper layer resist film on a substrate to be processed; forming an upper layer resist pattern; transferring the upper layer resist pattern to the tin-containing middle layer film, and forming an organic underlayer film pattern on an upper portion of which a portion of the tin-containing middle layer film is left; removing the portion of the tin-containing middle layer film by dry-etching; forming an inorganic silicon-containing film so as to cover the organic underlayer film pattern; exposing the upper portion of the organic underlayer film pattern; removing the organic underlayer film pattern to form an inorganic silicon-containing film pattern with a pattern pitch that is 1/2 of that of the upper layer resist pattern; and processing the substrate to be processed while using the inorganic silicon-containing film pattern as a mask to form a pattern in the substrate to be processed.

## Description

### TECHNICAL FIELD

The present invention relates to a patterning process by a sidewall spacer method.

### BACKGROUND ART

In 1980s, photo exposure using exposure light of a g-line (436 nm) or an i-line (365 nm) of a mercury lamp as a light source had been widely used in resist patterning. As a means for further miniaturization, shifting to exposure light having shorter wavelengths was considered effective, and in the mass production process of dynamic random access memory (DRAM) with 64 megabits (processing dimension of 0.25 um or less) in 1990s and later, a KrF excimer laser (248 nm) with a shorter wavelength had been used in place of the i-line as an exposure light source.

However, in production of DRAMs with integration of 256 MB and 1 GB or higher which require further miniaturized process technologies (processing dimension of 0.2 um or less), a light source with a shorter wavelength is required. Photolithography using an ArF excimer laser (193 nm) has been investigated seriously over a decade. At first, it was expected that the ArF lithography would be applied to the fabrication of 180 nm-node devices. However, the KrF excimer lithography had been used until the mass production of 130 nm-node devices. The full-fledged application of the ArF lithography started from the 90 nm-node. Further, the mass production of 65 nm-node devices is underway by combining the ArF lithography with a lens having an increased numerical aperture (NA) of 0.9. In pursuit of further shortening the exposure light wavelength for the next 45 nm-node devices, F₂ lithography with 157 nm wavelength emerged as a candidate. However, the F₂ lithography has various problems including: increased cost for a scanner due to use of large quantities of expensive CaF₂ single crystal for a projection lens; extremely poor durability of a soft pellicle and thus introduction of a hard pellicle, leading to change of optical systems; and decrease in etching resistance of a resist film. Because of these problems, development of the F₂ lithography was suspended, and the ArF immersion lithography was introduced.

In the ArF immersion lithography, water having a refractive index of 1.44 is introduced between a projection lens and a wafer by a partial fill method, thereby enabling high speed scanning. Thus, mass production of the 45 nm-node devices is now underway by using a lens with a NA of 1.3.

As the 32 nm-node lithography technology, extreme ultraviolet lithography (EUV) with 13.5 nm wavelength in vacuum is now in practical use. In the photo exposure used as common technology, the resolution based on the wavelength of a light source is approaching its inherent limit.

Against this background, one of miniaturization technologies that have recently attracted attention is a double patterning process, in which a pattern is formed by a first exposure and development, and then a pattern is formed exactly in the spaces of the first pattern by a second exposure (Non Patent Document 1). Many processes have been proposed as double patterning methods. For example, (1) a photoresist pattern with a line-and-space interval of 1:3 is formed by a first exposure and development; an underlayer hard mask is processed by dry-etching; another hard mask is formed thereon; a line pattern is formed by exposure and development for a photoresist film in a space portion formed by the first exposure; and the hard mask is then processed by dry-etching to form a line-and-space pattern having a pitch half the first pattern pitch. According to another example, (2) a photoresist pattern with a space-and-line interval of 1:3 is formed by a first exposure and development; an underlayer hard mask is processed by dry-etching; a photoresist film is applied thereon; the remaining part of the hard mask is subjected to exposure for a second space pattern; and the hard mask is then processed by dry-etching. In both of these methods, the hard mask is processed twice by dry-etching.

In the former method, the hard mask needs to be formed twice. The latter method only requires one layer of the hard mask but requires formation of a trench pattern which is more difficult to achieve resolution than a line pattern. Moreover, in the latter method, a negative resist material may be used to form the trench pattern. In this method, high-contrast light similar to that for forming a line using a positive development pattern can be used. However, a negative resist material has a lower dissolution contrast than a positive resist material. Thus, in comparison between forming a line with a positive resist material and forming a trench pattern of the same dimensions with a negative resist material, the resolution is lower when using a negative resist material. In the latter method, a thermal flow method may be employed in which a wide trench pattern is formed using a positive resist material, and the trench pattern is then shrunk by heating the substrate. Alternatively, a RELACS method may be employed in which a trench pattern after development is coated with a water-soluble film, and the trench is shrunk by heating and crosslinking of the resist film surface. These methods, however, have drawbacks such as deterioration in proximity bias and low throughput due to further complicated process.

In both of the former and latter methods, the substrate needs to be etched twice. This causes lower throughput as well as pattern deformation and misalignment due to two etchings.

To perform etching only once, one method is to use a negative resist material in the first exposure and use a positive resist material in the second exposure. Another method is to use a positive resist material in the first exposure and use a negative resist material dissolved in a higher alcohol with four or more carbon atoms that does not dissolve the positive resist material in the second exposure. In these methods, the resolution is lowered because a negative resist material having a low resolution is used.

Yet another method has been proposed, in which a pattern formed by a first exposure and development is treated with a reactive metal compound to insolubilize the pattern, and then a second pattern is newly formed in an intermediate space of the first pattern by exposure and development (Patent Document 1).

The most critical problem in such double patterning is the overlay accuracy of the first and second patterns. Variation of the line dimensions depends on the magnitude of position displacement. Thus, for example, to form 32-nm lines with 10% accuracy, the overlay accuracy within 3.2 nm is necessary. Because the overlay accuracy of a current scanner is about 8 nm, a significant improvement of the accuracy is necessary.

Because of the problem of the scanner overlay accuracy and the difficulty to divide one pattern into two, a method for reducing the pitch to half in one exposure has been contemplated. For example, a sidewall spacer method has been proposed in which a pitch is reduced to half by forming films on both sides of a line pattern sidewall (Non Patent Document 2). A spacer space method and a spacer line method have been proposed as the sidewall spacer method. In the spacer space method, a hard mask of a resist underlayer and a film embedded in a space between films attached on sidewalls of the hard mask are used as an etching pattern. In the spacer line method, films attached on hard mask sidewalls of a resist underlayer are used as an etching pattern (Non Patent Document 3).

As the sidewall spacer method, another method has been proposed in which sidewalls of SiO₂, α-Si, α-C, or the like are formed in a core pattern by a CVD method, and then the core pattern is removed by dry-etching, thereby forming the sidewall pattern, so that the pattern pitch is halved. In a multilayer resist process using an organic resist underlayer film and a silicon-containing middle layer film, a resist pattern is transferred by dry-etching to a core material formed of an organic underlayer film, then sidewalls are formed on the core material having the transferred pattern, and subsequently, the core material is removed to form a pattern with a 1/2 pattern pitch. However, when the core material which is unnecessary after forming the sidewalls is removed, the silicon-containing middle layer film is left on an upper portion of the organic underlayer film. In order to remove the silicon-containing middle layer film, dry-etching using fluorine gas needs to be performed. The dry-etching step for removing the silicon-containing middle layer film damages the substrate. This leads to unsatisfactory performance of products and yield decrease.

A method of removing the silicon-containing middle layer film left on the organic underlayer film without damaging the substrate has been proposed, in which the silicon-containing middle layer film left on an upper portion of the organic underlayer film is washed and removed with a stripper that does not damage the organic underlayer film or the substrate, and an inorganic silicon film pattern (sidewall pattern) is formed with a pattern pitch that is 1/2 of that of the upper layer resist pattern (Patent Document 2). On other hand, in forming a finer pattern, a wet stripping process has the risk of causing pattern collapse. Thus, there has been a demand for a practical patterning process using dry-etching.

### CITATION LIST

### PATENT LITERATURE

Patent Document 1: JP 2008-33174 A
Patent Document 2: JP 2020-111727 A

### NON PATENT LITERATURE

Non Patent Document 1: Proc. SPIE Vol. 5754 p. 1508 (2005)
Non Patent Document 2: J. Vac. Sci. Technol. B17(6), Nov/Dec 1999
Non Patent Document 3: Fourth International Symposium on Liquid Immersion (2007), Presentation No. PR-01, Title: Implementation of immersion lithography to NAND/CMOS lithography to NAND/CMOS device manufacturing

### SUMMARY OF INVENTION

### TECHNICAL PROBLEM

The sidewall spacer method using an organic resist underlayer film as a core material is useful for forming a fine pattern. However, in a combination of an organic resist underlayer film and a silicon-containing middle layer film, which is a mainstream of the multilayer resist process, the point at issue is how the silicon-containing middle layer film left on the organic resist underlayer film is to be removed.

In view of the above circumstances, the present invention aims to provide a patterning process capable of forming a finer pattern readily and efficiently and forming a pattern with high smoothness, without damaging a substrate.

### SOLUTION TO PROBLEM

To achieve the object, the present invention provides a patterning process for forming a pattern in a substrate to be processed. The method includes steps of:
(i-1) forming an organic underlayer film in a substrate to be processed, forming a tin-containing middle layer film on the organic underlayer film, and further forming an upper layer resist film on the tin-containing middle layer film;
(i-2) performing pattern exposure and subsequent development in the upper layer resist film to form an upper layer resist pattern;
(i-3) dry-etching the tin-containing middle layer film while using the upper layer resist pattern as a mask to transfer the upper layer resist pattern to the tin-containing middle layer film, and further dry-etching the organic underlayer film while using the tin-containing middle layer film having the transferred upper layer resist pattern as a mask to form an organic underlayer film pattern on an upper portion of which a portion of the tin-containing middle layer film is left;
(i-4) removing the portion of the tin-containing middle layer film left on the upper portion of the organic underlayer film pattern by dry-etching;
(i-5) forming an inorganic silicon-containing film comprising polysilicon, amorphous silicon, silicon oxide, silicon nitride, silicon oxynitride, silicon carbide, or a composite material thereof, by a CVD method or an ALD method, so as to cover the organic underlayer film pattern;
(i-6) removing a portion of the inorganic silicon-containing film by dry-etching to expose the upper portion of the organic underlayer film pattern;
(i-7) removing the organic underlayer film pattern to form an inorganic silicon-containing film pattern with a pattern pitch that is 1/2 of a pattern pitch of the upper layer resist pattern; and
(i-8) processing the substrate to be processed while using the inorganic silicon-containing film pattern as a mask to form a pattern in the substrate to be processed.

With such a patterning process, the tin-containing middle layer film and the organic underlayer film that form the core material can be removed by dry-etching without damaging the inorganic silicon-containing film that forms sidewalls or the substrate, so that the inorganic silicon-containing film pattern (sidewall pattern) with a pattern pitch that is 1/2 of that of the upper layer resist pattern can be formed readily and efficiently without causing unsatisfactory performance of products or yield decrease.

Further, the present invention provides a patterning process for forming a pattern in a substrate to be processed. The method includes steps of:
(ii-1) forming an organic underlayer film on a substrate to be processed, forming a tin-containing middle layer film on the organic underlayer film, and further forming an upper layer resist film on the tin-containing middle layer film;
(ii-2) performing pattern exposure and subsequent development in the upper layer resist film to form an upper layer resist pattern;
(ii-3) dry-etching the tin-containing middle layer film while using the upper layer resist pattern as a mask to transfer the upper layer resist pattern to the tin-containing middle layer film, and further dry-etching the organic underlayer film while using the tin-containing middle layer film having the transferred upper layer resist pattern as a mask to form an organic underlayer film pattern on an upper portion of which a portion of the tin-containing middle layer film is left;
(ii-4) forming an inorganic silicon-containing film comprising polysilicon, amorphous silicon, silicon oxide, silicon nitride, silicon oxynitride, silicon carbide, or a composite material thereof, by a CVD method or an ALD method, so as to cover the portion of the tin-containing middle layer film and the organic underlayer film pattern;
(ii-5) removing a portion of the inorganic silicon-containing film by dry-etching to expose an upper portion of the portion of the tin-containing middle layer film;
(ii-6) removing the portion of the tin-containing middle layer film left on the upper portion of the organic underlayer film pattern by dry-etching;
(ii-7) removing the organic underlayer film pattern by dry-etching to form an inorganic silicon-containing film pattern with a pattern pitch that is 1/2 of a pattern pitch of the upper layer resist pattern; and
(ii-8) processing the substrate to be processed while using the inorganic silicon-containing film pattern as a mask to form a pattern in the substrate to be processed.

With such a patterning process, the tin-containing middle layer film and the organic underlayer film that form the core material can be removed by dry-etching without damaging the inorganic silicon-containing film that forms sidewalls or the substrate, so that the inorganic silicon-containing film pattern (sidewall pattern) with a pattern pitch that is 1/2 of that of the upper layer resist pattern can be formed readily and efficiently without causing unsatisfactory performance of products or yield decrease.

It is preferable that in the step (i-4) or (ii-6), the tin-containing middle layer film is etched by plasma formed in a H₂-containing gas.

By using a H₂-containing gas, the tin-containing middle layer film can be removed without damaging the inorganic silicon-containing film that forms sidewalls or the substrate.

It is preferable that the tin-containing middle layer film is formed by spin coating using a composition for forming a tin-containing middle layer film.

When the patterning process for forming the tin-containing middle layer film is spin coating using a composition for forming a tin-containing middle layer film, the tin-containing middle layer film can be formed inexpensively and efficiently.

It is preferable that the tin-containing middle layer film is formed from a composition for forming a tin-containing middle layer film, the composition comprising a compound having a crosslinkable organic structure.

The use of the tin-containing middle layer film formed using a composition for forming a tin-containing middle layer film that contains a crosslinkable organic structure is advantageous to fine pattern formation, because a pattern with high smoothness can be transferred to the organic underlayer film.

In this case, it is preferable that the compound having one or more selected from the group consisting of:
a hydroxyl group;
an organic group having a protective group which is to be eliminated by an action of acid or heat or both to generate one or more hydroxyl groups or carboxyl groups; and
an organic group represented by any one of the following general formulae (a-1) to (a-3) and (b-1) to (b-4)
   is used as the crosslinkable organic structure: 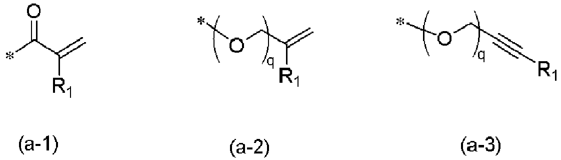
(in the general formulae (a-1) to (a-3), R₁ represents a hydrogen atom or a monovalent organic group having 1 to 10 carbon atoms, q represents 0 or 1, and * represents a bonding point) 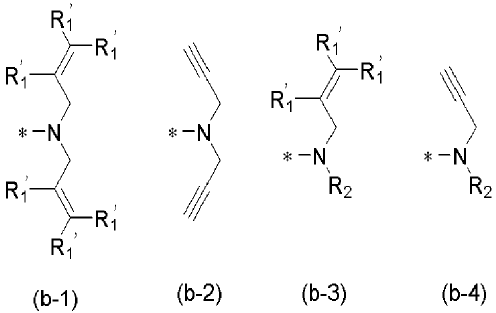
(in the general formulae (b-1) and (b-3), R₁' represents a hydrogen atom or a methyl group, and in the same formula, they may be the same or different; in (b-3) to (b-4), R₂ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms; * represents a bonding point).

The use of the compound having such a crosslinkable organic structure is more advantageous to fine pattern formation, because a pattern with higher smoothness can be transferred to the organic underlayer film.

It is preferable that in the step (i-1) or (ii-1), a water-repellent coating film is further formed on the upper layer resist film.

Such a patterning process can be employed when a protective film for the upper layer resist is necessary to use immersion exposure in forming the upper layer resist pattern.

It is preferable that in the step (i-1) or (ii-1), an organic adhesive film is formed in middle between the tin-containing middle layer film and the upper layer resist film.

By forming an organic adhesive film in the middle between the tin-containing middle layer film and the upper layer resist film, a satisfactory pattern shape can be obtained in pattern formation in the upper layer resist film and collapse of a fine pattern can also be suppressed.

### ADVANTAGEOUS EFFECTS OF INVENTION

As described above, the patterning process according to the present invention is a patterning process for forming a fine pattern using a sidewall spacer process, in which the tin-containing middle layer film and the organic underlayer film that form the core material can be removed by dry-etching without damaging the inorganic silicon-containing film that forms sidewalls or the substrate. Thus, a practical patterning process can be provided that can readily and efficiently form an inorganic silicon-containing film pattern (sidewall pattern) with a pattern pitch that is 1/2 of that of the upper layer resist pattern, without causing unsatisfactory performance of products or yield decrease.

### BRIEF DESCRIPTION OF DRAWINGS

FIG. 1 is an illustration of an example of a first aspect of a patterning process according to the present invention; and
FIG. 2 is an illustration of an example of a second aspect of a patterning process according to the present invention.

### DESCRIPTION OF EMBODIMENTS

As described above, with recent miniaturization of pattern rules, there has been a demand for a practical patterning process that readily and efficiently can form finer patterns and can be applied to a semiconductor manufacturing process.

The inventors of the present invention have conducted elaborate studies to achieve the object and found a tin-containing middle layer film and an organic resist underlayer film readily removable by dry-etching can be used to provide a practical patterning process that can readily and efficiently form an inorganic silicon-containing film pattern (sidewall pattern) with a pattern pitch that is 1/2 of that of an upper layer resist pattern, without damaging the inorganic silicon-containing film that forms sidewalls or the substrate. This finding has led to completion of the present invention.

Specifically, a first aspect of the present invention provides a patterning process for forming a pattern in a substrate to be processed. The method includes steps of:
(i-1) forming an organic underlayer film on a substrate to be processed, forming a tin-containing middle layer film on the organic underlayer film, and further forming an upper layer resist film on the tin-containing middle layer film;
(i-2) performing pattern exposure and subsequent development in the upper layer resist film to form an upper layer resist pattern;
(i-3) dry-etching the tin-containing middle layer film while using the upper layer resist pattern as a mask to transfer the upper layer resist pattern to the tin-containing middle layer film, and further dry-etching the organic underlayer film while using the tin-containing middle layer film having the transferred upper layer resist pattern as a mask to form an organic underlayer film pattern on an upper portion of which a portion of the tin-containing middle layer film is left;
(i-4) removing the portion of the tin-containing middle layer film left on the upper portion of the organic underlayer film pattern by dry-etching;
(i-5) forming an inorganic silicon-containing film comprising polysilicon, amorphous silicon, silicon oxide, silicon nitride, silicon oxynitride, silicon carbide, or a composite material thereof, by a CVD method or an ALD method, so as to cover the organic underlayer film pattern;
(i-6) removing a portion of the inorganic silicon-containing film by dry-etching to expose the upper portion of the organic underlayer film pattern;
(i-7) removing the organic underlayer film pattern to form an inorganic silicon-containing film pattern with a pattern pitch that is 1/2 of a pattern pitch of the upper layer resist pattern; and
(i-8) processing the substrate to be processed while using the inorganic silicon-containing film pattern as a mask to form a pattern in the substrate to be processed.

A second aspect of the present invention provides a patterning process for forming a pattern in a substrate to be processed. The method includes steps of:
(ii-1) forming an organic underlayer film on a substrate to be processed, forming a tin-containing middle layer film on the organic underlayer film, and further forming an upper layer resist film on the tin-containing middle layer film;
(ii-2) performing pattern exposure and subsequent development in the upper layer resist film to form an upper layer resist pattern;
(ii-3) dry-etching the tin-containing middle layer film while using the upper layer resist pattern as a mask to transfer the upper layer resist pattern to the tin-containing middle layer film, and further dry-etching the organic underlayer film while using the tin-containing middle layer film having the transferred upper layer resist pattern as a mask to form an organic underlayer film pattern on an upper portion of which a portion of the tin-containing middle layer film is left;
(ii-4) forming an inorganic silicon-containing film comprising polysilicon, amorphous silicon, silicon oxide, silicon nitride, silicon oxynitride, silicon carbide, or a composite material thereof, by a CVD method or an ALD method, so as to cover the portion of the tin-containing middle layer film and the organic underlayer film pattern;
(ii-5) removing a portion of the inorganic silicon-containing film by dry-etching to expose an upper portion of the portion of the tin-containing middle layer film;
(ii-6) removing the portion of the tin-containing middle layer film left on the upper portion of the organic underlayer film pattern by dry-etching;
(ii-7) removing the organic underlayer film pattern by dry-etching to form an inorganic silicon-containing film pattern with a pattern pitch that is 1/2 of a pattern pitch of the upper layer resist pattern; and
(ii-8) processing the substrate to be processed while using the inorganic silicon-containing film pattern as a mask to form a pattern in the substrate to be processed.

The present invention will be described in detail below; however, the present invention is not intended to be limited by the description.

### <Patterning Process>

A first aspect of the patterning process according to the present invention includes the above steps (i-1) to (i-8).

With such a patterning process, a practical patterning process can be provided that can readily and efficiently form an inorganic silicon-containing film pattern (sidewall pattern) with a pattern pitch that is 1/2 of that of an upper layer resist pattern, without damaging the inorganic silicon-containing film that form sidewalls or the substrate.

A second aspect of the patterning process according to the present invention includes the above steps (ii-1) to (ii-8).

With such a patterning process, a practical patterning process can be provided that can readily and efficiently form an inorganic silicon-containing film pattern (sidewall pattern) with a pattern pitch that is 1/2 of that of the upper layer resist pattern, without damaging the inorganic silicon-containing film that form sidewalls or the substrate to be processed. In (ii-6) and (ii-7), the tin-containing middle layer film and the organic underlayer film can be removed by dry-etching simultaneously (successively), which is preferable in terms of productivity.

Hereinafter, the steps will be described in detail in order with reference to the drawings. It should be noted that step (i-1) to step (i-3) in the first aspect are the same as step (ii-1) to step (ii-3) in the second aspect. Hence, first, these steps will be collectively explained.

### [Steps (i-1) and (ii-1)]

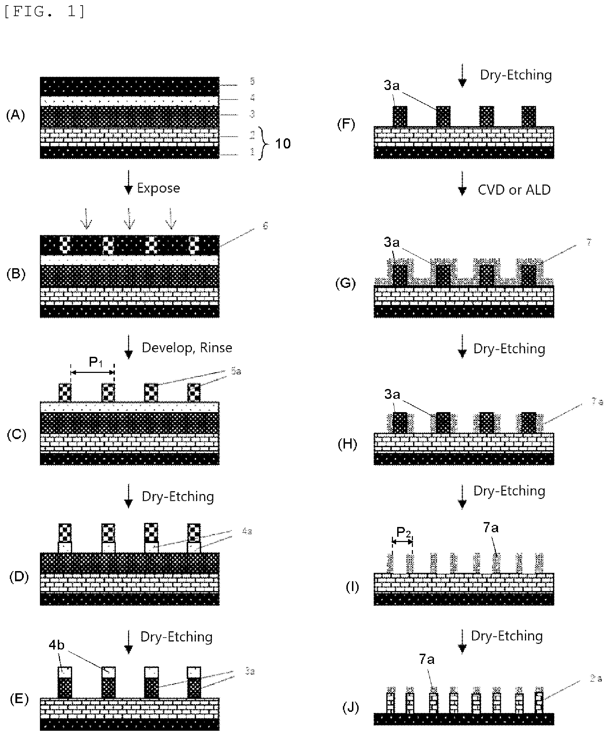

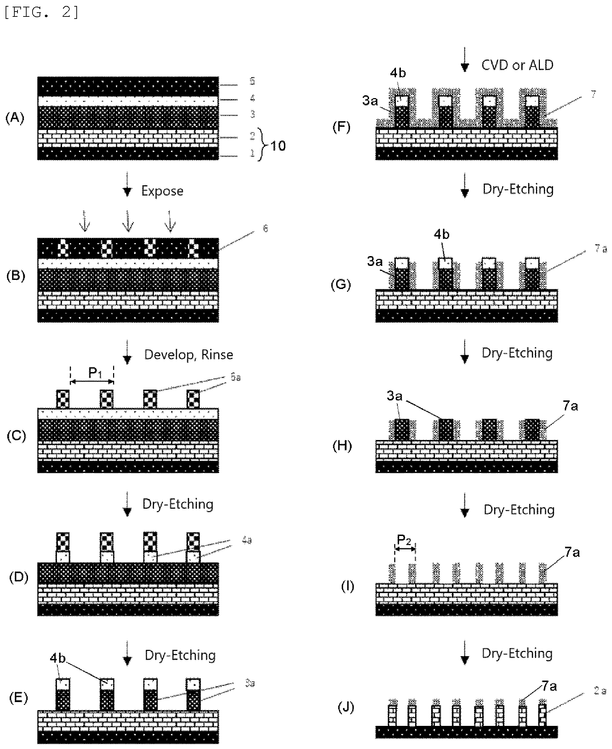

As illustrated in FIG. 1(A) and FIG. 2(A), steps (i-1) and (ii-1) are steps of forming an organic underlayer film 3 on a substrate 10 to be processed, forming a tin-containing middle layer film 4 on the organic underlayer film 3, and further forming an upper layer resist film 5 on the tin-containing middle layer film 4. FIG. 1(A) and FIG. 2(A) illustrate an example in which a layer 2 to be processed is formed on a substrate 1 to make the substrate 10 to be processed, and the organic underlayer film 3 is formed on the layer 2 to be processed of the substrate 10 to be processed.

### <Substrate to be Processed>

For example, a substrate for manufacturing a semiconductor can be used as the substrate 1. For example, a film formed of one of a metal film, a metal carbide film, a metal oxide film, a metal nitride film, and a composite film thereof can be used as the layer 2 to be processed (portion to be processed) on the substrate 1.

A silicon substrate is commonly used as the substrate for manufacturing a semiconductor. However, the present invention is not limited to this, and a material different from the layer to be processed, such as Si, amorphous silicon (α-Si), p-Si, SiO₂, SiN, SiON, W, TiN, or Al, may be used.

Any one of silicon, titanium, tungsten, hafnium, zirconium, chromium, germanium, copper, aluminum, and iron, or an alloy thereof can be used as a metal that constitutes the layer 2 to be processed. As the layer 2 to be processed containing such a metal, for example, Si, SiO₂, SiN, SiON, SiOC, p-Si, α-Si, TiN, WSi, BPSG, SOG, Cr, CrO, CrON, MoSi, W, W-Si, Al, Cu, Al-Si, and the like, and a variety of low dielectric films and an etching stopper film thereof may be used and formed to a thickness of typically 50 to 10,000 nm, particularly 100 to 5,000 nm.

### <Organic Underlayer Film>

When the organic underlayer film (for example, resist underlayer film) 3 is formed on the substrate 10 to be processed, the organic underlayer film 3 can be formed by spin coating using an application-type organic underlayer film material, a CVD method, or an ALD method.

Examples of the application-type organic underlayer film material include resins and compositions disclosed in WO 2007/105776 A1, WO 2009/72465 A1, WO 2010/61774 A1, WO 2010/147155 A1, WO 2011/125839 A1, WO 2012/50064 A1, WO 2012/77640 A1, WO 2013/5797 A1, WO 2013/47106 A1, WO 2013/47516 A1, WO 2013/80929 A1, WO 2013/115097 A1, WO 2013/146670 A1, WO 2014/24836 A1, WO 2014/208324 A1, WO 2014/208499 A1, WO 2015/170736 A1, WO 2015/194273 A1, WO 2016/147989 A1, JP 2001-40293 A, JP 2002-214777 A, JP 2002-296789 A, JP 2004-205685 A, JP 2004-264710 A, JP 2005-043471 A, JP 2005-250434 A, JP 2005-128509 A, JP 2006-259249 A, JP 2006-285046 A, JP 2007-171895 A, JP 2007-199653 A, JP 2007-293294 A, JP 2008-65303 A, JP 2008-65081 A, JP 2008-274250 A, JP 2009-14816 A, JP 2009-229666 A, JP 2009-251130 A, JP 2010-122656 A, JP 2010-15112 A, JP 2010-271654 A, JP 2011-107684 A, JP 2011-170059 A, JP 2012-1687 A, JP 2012-77295 A, JP 2012-214720 A, JP 2012-215842 A, JP 2013-83939 A, JP 2014-24831 A, JP 2014-157169 A, JP 2015-131954 A, JP 2015-183406 A, JP 2016-29160 A, JP 2016-44272 A, JP 2016-60886 A, JP 2016-145849 A, JP 2016-167047 A, JP 2016-216367 A, JP 2017-3959 A, JP 2017-119670 A, JP 2017-119671 A, JP 2013-516643 A, JP 2015-515112 A, JP 2019-44022 A, and the like. In the present invention, it is preferable to use a resin containing an aromatic skeleton-containing compound such as a naphthalene skeleton-containing compound, a fluorene skeleton-containing compound, a carbazole skeleton-containing compound, an acenaphthylene skeleton-containing compound, a naphthol skeleton-containing compound, and a bisnaphthol skeleton-containing compound.

When the organic underlayer film 3 is formed by spin coating, it is preferable to evaporate a solvent after spin coating and perform baking (heat treatment) for accelerating a crosslinking reaction in order to prevent mixing with the upper layer resist film 5 and a middle layer film (for example, the tin-containing middle layer film or the optional organic adhesive film). Baking is performed preferably in a range from 100°C to 600°C for 10 to 600 seconds, more preferably in a range from 200°C to 500°C for 10 to 300 seconds. Considering the effects on device damage and wafer deformation, the upper limit of heating temperature in a wafer process in lithography is preferably 600°C or lower, more preferably 500°C or lower.

The organic underlayer film 3 can also be formed by applying a composition for forming an organic underlayer film on the substrate 10 to be processed by spin coating or the like in the same manner as described above, and baking and curing the composition for forming an organic underlayer film in an atmosphere with an oxygen concentration of 0.1% by volume or more and 21% by volume or less.

By baking the composition for forming an organic underlayer film in such an oxygen atmosphere, the organic underlayer film 3 hardened sufficiently can be obtained. The atmosphere during baking may be in the air, but preferably filled with an inert gas such as N₂, Ar, and He for reducing oxygen in order to prevent oxidation of the organic underlayer film 3. The oxygen concentration needs to be controlled in order to prevent oxidation and is preferably 1000 ppm or less, more preferably 100 ppm or less (volumetric basis). It is preferable to prevent oxidation of the organic underlayer film 3 during baking, because if so, increase in absorption or decrease in etching resistance is prevented.

### <Tin-Containing Middle Layer Film>

The tin-containing middle layer film 4 can be readily removed by dry-etching. Unlike a case where a silicon-containing middle layer film is used as a middle layer film, such a tin-containing middle layer film 4 can be easily removed by dry-etching without damaging the substrate to be processed, or the substrate to be processed and the inorganic silicon-containing film that forms sidewalls, thereby eliminating the problems such as performance deterioration of products and yield decrease.

The tin-containing middle layer film 4 used in the patterning process in the present invention is not limited, but the tin-containing middle layer film 4 excellent in heat resistant characteristics, solvent resistance, and adhesiveness to the upper layer resist film 5 is preferred because it is necessary to form the upper layer resist film 5 on the tin-containing middle layer film 4. When the tin-containing middle layer film 4 is formed, the tin-containing middle layer film 4 can be formed by a method using an application-type composition for forming a tin-containing middle layer film, a CVD method, an ALD method, or the like. Spin coating using an application-type composition for forming a tin-containing middle layer film is preferred in that the tin-containing middle layer film 4 can be formed inexpensively and efficiently.

As the application-type composition for forming a tin-containing middle layer film, it is preferable to use the one containing a compound having a crosslinkable organic structure.

The use of a composition for forming a tin-containing middle layer film containing a compound having a crosslinkable organic structure can improve heat resistance characteristics and solvent resistance required in forming the upper layer resist film 5, and adhesiveness to the upper layer resist film 5.

It is preferable that the compound having one or more selected from the group consisting of:
a hydroxyl group;
an organic group having a protective group which is to be eliminated by an action of acid or heat or both to generate one or more hydroxyl groups or carboxyl groups; and
an organic group represented by any one of the following general formulae (a-1) to (a-3) and (b-1) to (b-4)
   is used as the crosslinkable organic structure: 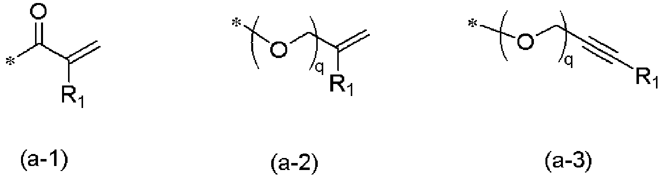
(in the general formulae (a-1) to (a-3), R₁ represents a hydrogen atom or a monovalent organic group having 1 to 10 carbon atoms, q represents 0 or 1, and * represents a bonding point) 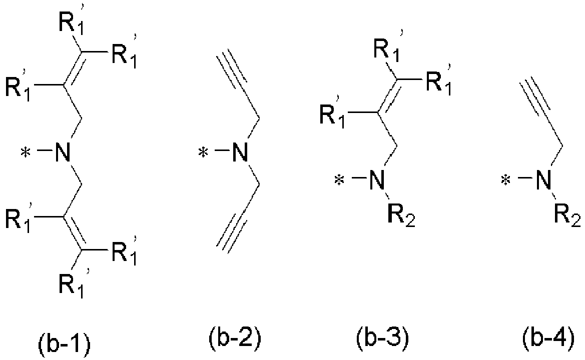
(in the general formulae (b-1) and (b-3), R₁' represents a hydrogen atom or a methyl group, and in the same formula, they may be the same or different; in (b-3) to (b-4), R₂ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms; * represents a bonding point).

In the general formulae (a-1) to (a-3), R₁ is preferably a hydrogen atom or a methyl group, and q is preferably 0 or 1. In the general formulae (b-1) and (b-3), R₁' is preferably a hydrogen atom.

The use of such a composition having a crosslinkable organic structure can further improve heat resistance characteristics and solvent resistance required in forming the upper layer resist film 5, and adhesiveness to the upper layer resist film 5.

Examples of the compound having a crosslinkable organic structure include the following compounds. However, the compound used in the present invention is not limited thereto. 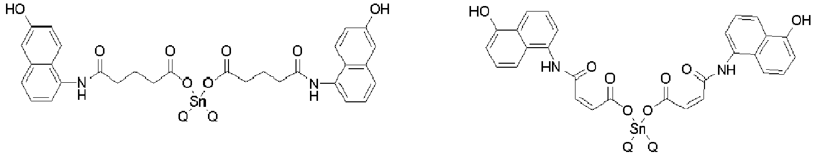 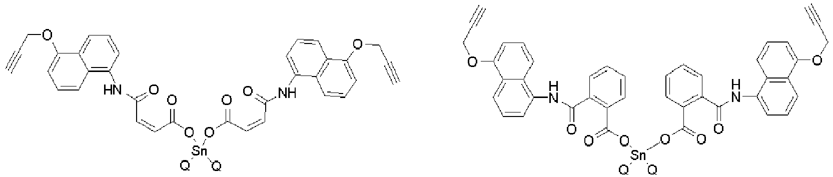 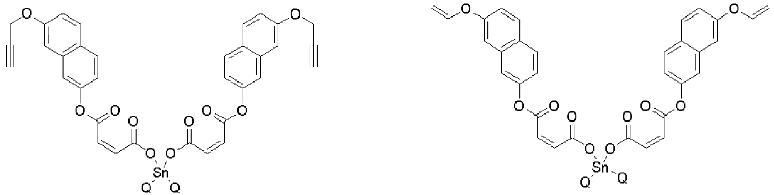 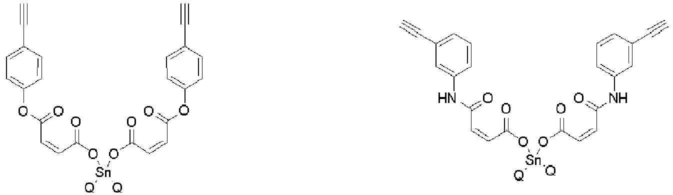 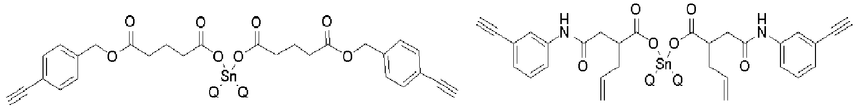 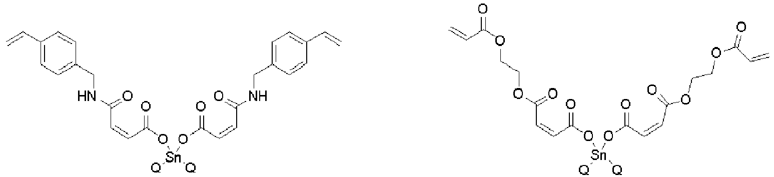 (In the above formulae, Q is a hydrocarbon group having 1 to 20 carbon atoms.) 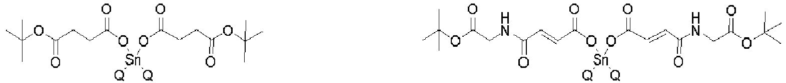 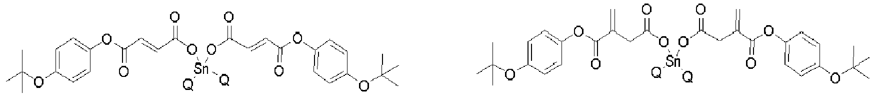 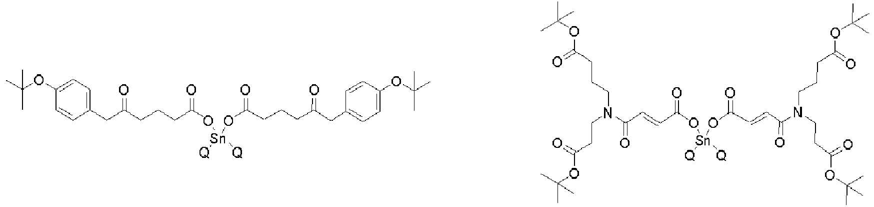 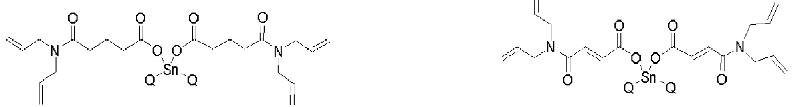 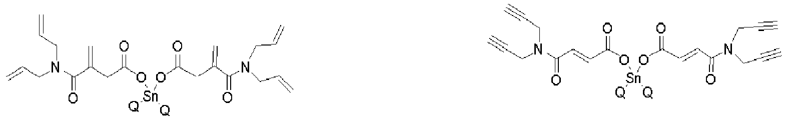 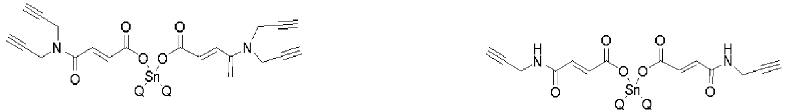 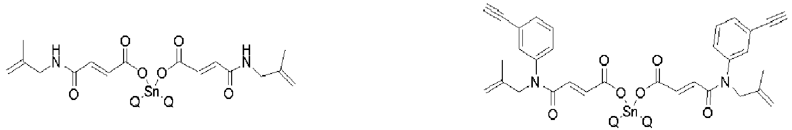 (In the above formulae, Q is a hydrocarbon group having 1 to 20 carbon atoms.) 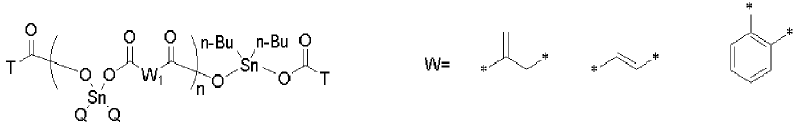 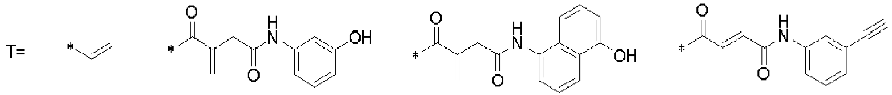 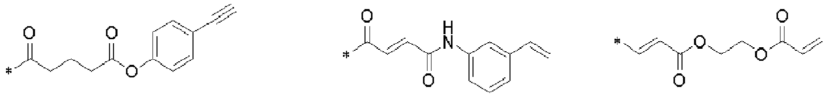 (In the above formulae, n is 1 to 30, Q is a hydrocarbon group having 1 to 20 carbon atoms, and * represents a bonding point.) 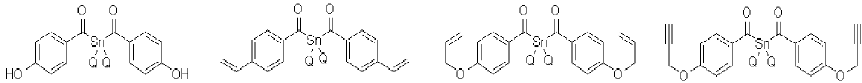 (In the above formulae, Q is a hydrocarbon group having 1 to 20 carbon atoms.)

In the above formulae, Q is preferably an n-butyl group or an n-octyl group.

Other examples include the following compounds disclosed in WO 2018/123388 A1, JP 6591058 B, JP 7096814 B, and JP 2021-179606 A.

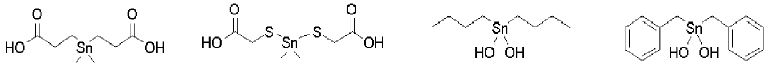

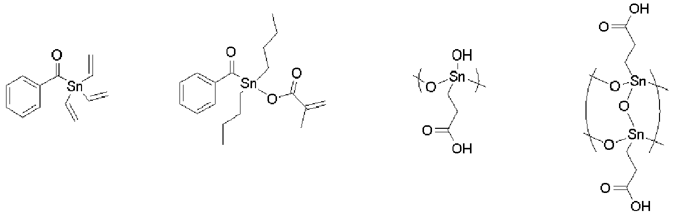

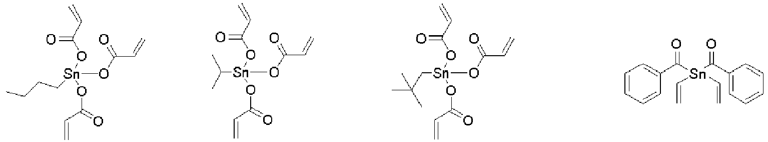

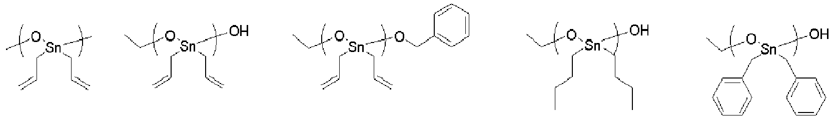

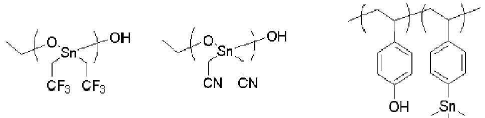

When the tin-containing middle layer film is formed by spin coating, the solvent is evaporated after spin coating, and baking (heat treatment) is performed for accelerating a crosslinking reaction in order to prevent mixing with the upper layer resist film or the resist middle layer film. Baking is performed preferably in a range from 100°C to 600°C for 10 to 600 seconds, more preferably in a range from 150°C to 500°C for 10 to 300 seconds. Considering the effects on device damage and wafer deformation, the upper limit of heating temperature in a wafer process in lithography is preferably 600°C or lower, more preferably 500°C or lower.

### <Upper Layer Resist Film>

The upper layer resist film 5 that can be used in the patterning process in the present invention is not limited, and any of various resist films conventionally known can be used. Although FIG. 1 and FIG. 2 illustrate an example in which a positive-type upper layer resist film 5 is used, the upper layer resist film 5 may be either a positive type or a negative type, and the same material as a photoresist composition commonly used can be used as its material.

When the upper layer resist film 5 is formed by spin coating, prebake is performed after resist application, preferably in a range from 60 to 180°C for 10 to 300 seconds. The thickness of the upper layer resist film 5 is preferably, but not limited to, 10 to 500 nm, and particularly preferably 20 to 400 nm.

### <Water-Repellent Coating Film>

When a protective film for the upper layer resist film 5 is necessary to use immersion exposure in forming the upper layer resist pattern in step (i-2) or step (ii-2) described below, a water-repellent coating film may be further formed on the upper layer resist film 5 in step (i-1) or step (ii-1). The water-repellent coating film is not limited and various ones can be used.

### <Organic Adhesive Film>

In (i-1) or (ii-1), it is preferable that an organic adhesive film is formed in middle between the tin-containing middle layer film 4 and the upper layer resist film 5.

By forming an organic adhesive film in the middle between the tin-containing middle layer film 4 and the upper layer resist film 5, a satisfactory pattern shape can be obtained in pattern formation of the upper layer resist film 5, and in addition, collapse of the fine pattern can be suppressed.

As the organic adhesive film, those conventionally known can be used.

### [Steps (i-2) and (ii-2)]

Steps (i-2) and (ii-2) each are a step of performing pattern exposure and subsequent development in the upper layer resist film 5 as illustrated in FIG. 1(B) and FIG. 2(B) to form an upper layer resist pattern 5a as illustrated in FIG. 1(C) and FIG. 2(C).

These steps can be performed according to an ordinary method. For example, the upper layer resist pattern 5a with a pattern pitch P₁ can be obtained by performing exposure and performing post-exposure bake (PEB) and development.

Examples of exposure light include high energy beams with a wavelength of 300 nm or less, specifically, 248 nm, 193 nm, or 157 nm excimer laser beams, 3 to 20 nm soft X-ray, electron beams, and X-ray.

The patterning process for the upper layer resist film is preferably photolithography with a wavelength of 5 nm to 300 nm, direct drawing by electron beams, nanoimprinting, or a combination thereof.

The development method in the patterning process is preferably alkaline development or development by an organic solvent.

In FIG. 1(B) and (C), and FIG. 2(B) and (C), an exposed portion 6 illustrated in FIG. 1(B) and FIG. 2(B) is removed by this development process and rinsed to form the upper layer resist pattern 5a.

### [Steps (i-3) and (ii-3)]

Steps (i-3) and (ii-3) each are a step of dry-etching the tin-containing middle layer film 4 while using the upper layer resist pattern 5a as a mask to transfer the upper layer resist pattern 5a to the tin-containing middle layer film 4 as illustrated in FIG. 1(D) and FIG. 2(D), and further dry-etching the organic underlayer film 3 while using the tin-containing middle layer film 4 having the transferred upper layer resist pattern 5a (tin-containing middle layer film pattern 4a) as a mask to form an organic underlayer film pattern 3a on an upper portion of which a portion 4b of the tin-containing middle layer film is left as illustrated in FIG. 1(E) and FIG. 2(E).

In steps (i-3) and (ii-3), when the tin-containing middle layer film 4 is etched by dry-etching in a dry-etching condition in which the etching rate of the tin-containing middle layer film 4 is dominantly high relative to the upper layer resist pattern 5a, for example, with plasma formed in a H₂-containing gas while using the upper layer resist pattern 5a as an etching mask, the upper layer resist pattern 5a can be transferred to the tin-containing middle layer film 4 almost without being affected by pattern change due to side etching of the upper layer resist pattern 5a, resulting in a tin-containing middle layer film pattern 4a.

Subsequently, when reactive dry-etching is performed on the substrate having the tin-containing middle layer film 4 having the transferred upper layer resist pattern 5a (tin-containing middle layer film pattern 4a), in a dry-etching condition in which the etching rate of the organic underlayer film 3a is dominantly high relative to the tin-containing middle layer film 4, for example, with gas plasma containing oxygen, the organic underlayer film 3 can be etched as illustrated in FIG. 1(E) and FIG. 2(E).

While the organic underlayer film pattern 3a can be obtained through this etching step, the upper layer resist layer 5 as the top layer is usually lost at the same time. On the other hand, the portion 4b of the tin-containing middle layer film 4 serving as an etching mask is left on the upper portion of the organic underlayer film pattern 3a.

The following steps are different between the first aspect and the second aspect. Thus, each step in the first aspect will be described first, and each step in the second aspect will be described next.

### <First Aspect>

In the first aspect, steps (i-4) to (i-8) described below are performed after step (i-3).

### [Step (i-4)]

As illustrated in FIG. 1(F), step (i-4) is a step of removing the portion 4b of the tin-containing middle layer film left on the upper portion of the organic underlayer film pattern 3a by dry-etching.

In step (i-4), the removal of the portion 4b of the tin-containing middle layer film left on the organic underlayer film pattern 3a can be performed, for example, under a condition where the portion 4b of the tin-containing middle layer film can be selectively removed without damaging the substrate (substrate 10 to be processed), for example, by dry-etching with plasma formed in a H₂-containing gas.

### [Step (i-5)]

As illustrated in FIG. 1(G), step (i-5) is a step of forming an inorganic silicon-containing film 7 including polysilicon, amorphous silicon, silicon oxide, silicon nitride, silicon oxynitride, silicon carbide, or a composite material thereof, by a CVD method or an ALD method, so as to cover the organic underlayer film pattern 3a.

### [Step (i-6)]

Step (i-6) is a step of removing a portion of the inorganic silicon-containing film by dry-etching to expose the upper portion of the organic underlayer film pattern 3a, as illustrated in FIG. 1(H). Through this step, a not-removed portion 7a of the inorganic silicon-containing film is left in the form of a pattern.

The dry-etching condition here is not limited, and a gas condition and the like can be determined according to the composition of the inorganic silicon-containing film.

### [Step (i-7)]

Step (i-7) is a step of removing the organic underlayer film pattern 3a to form an inorganic silicon-containing film pattern 7a with a pattern pitch P₂ that is 1/2 of that of the upper layer resist pattern 5a (1/2 of the pattern pitch P₁) as illustrated in FIG. 1(I).

In step (i-7), the organic underlayer film pattern 3a can be removed under a condition where the organic underlayer film pattern 3a can be selectively removed without damaging the sidewalls formed of the inorganic silicon-containing film 7, for example, by dry-etching with gas plasma containing oxygen.

### [Step (i-8)]

Step (i-8) is a step of processing the substrate 10 to be processed while using the inorganic silicon-containing film pattern 7a as a mask to form a pattern 2a in the substrate 10 to be processed as illustrated in FIG. 1(J).

The processing of the substrate 10 to be processed can be performed in any dry-etching condition that is dominantly high relative to the inorganic silicon-containing film pattern and can be performed by an ordinary method. For example, when the body to be processed is SiO₂, SiN, or a silica-based low dielectric insulating film, etching based on a fluorocarbon gas is performed.

### <Second Aspect>

In the second aspect, steps (ii-4) to (ii-8) are performed after step (ii-3).

### [Step (ii-4)]

As illustrated in FIG. 2(F), step (ii-4) is a step of forming an inorganic silicon-containing film 7 including polysilicon, amorphous silicon, silicon oxide, silicon nitride, silicon oxynitride, silicon carbide, or a composite material thereof, by a CVD method or an ALD method, so as to cover the portion 4b of the tin-containing middle layer film 4 and the organic underlayer film pattern 3a.

### [Step (ii-5)]

Step (ii-5) is a step of removing a portion of the inorganic silicon-containing film 7 by dry-etching to expose an upper portion of the portion 4b of the tin-containing middle layer film, as illustrated in FIG. 2 (G). Through this step, a not-removed portion 7a of the inorganic silicon-containing film is left in the form of a pattern.

The dry-etching condition here is not limited, and a gas condition and the like can be determined according to the composition of the inorganic silicon-containing film 7.

### [Step (ii-6)]

As illustrated in FIG. 2(H), step (ii-6) is a step of removing the portion 4b of the tin-containing middle layer film left on the upper portion of the organic underlayer film pattern 3a by dry-etching.

In step (ii-6), the portion 4b of the tin-containing middle layer film can be removed under a condition where the portion 4b of the tin-containing middle layer film left on the organic underlayer film pattern 3a can be selectively removed without damaging the sidewalls formed of the inorganic silicon-containing film, for example, by dry-etching with gas plasma containing H₂.

### [Step (ii-7)]

Step (ii-7) is a step of removing the organic underlayer film pattern 3a by dry-etching to form an inorganic silicon-containing film pattern 7a with a pattern pitch P₂ that is 1/2 of that of the upper layer resist pattern 5a (1/2 of the pattern pitch P₁), as illustrated in FIG. 2(I).

In step (ii-7), the organic underlayer film pattern 3a can be removed under a condition where the organic underlayer film pattern 3a can be selectively removed without damaging the sidewalls formed of the inorganic silicon-containing film 7a, for example, by dry-etching with gas plasma containing oxygen.

### [Step (ii-8)]

Step (ii-8) is a step of processing the substrate 10 to be processed while using the inorganic silicon-containing film pattern 7a as a mask to form a pattern 2a in the substrate 10 to be processed as illustrated in FIG. 2(J).

This step (ii-8) is similar to step (i-8) in the first aspect.

In the patterning process in the present invention as described above, both when the residue of a material serving as a mask is present and when it is absent after pattern transfer by dry-etching, the inorganic silicon-containing film pattern (sidewall pattern) can be formed without damaging the sidewalls or the substrate.

The pattern transfer of a multilayer resist by dry-etching that is employed in the actual semiconductor device manufacturing process is often performed under a condition that a portion of a pattern material serving as a mask is left on the upper portion of the transferred pattern in order to ensure the rectangularity of the pattern shape after dry-etching. In other words, also in the patterning process in the present invention, when the pattern is transferred to the tin-containing middle layer film 4 by dry-etching using the upper layer resist pattern 5a as a mask, the step can proceed under a condition that a portion of the upper layer resist film 5 is left in order to ensure the rectangularity of the cross-sectional shape of the pattern 4a of the tin-containing middle layer film 4. When the pattern is subsequently transferred to the organic underlayer film 3 using the tin-containing middle layer film pattern 4a as a mask, the pattern transfer step can also proceed similarly in a state in which the portion 4b of the tin-containing middle layer film is left on the upper portion of the organic underlayer film pattern 3a in order to ensure the rectangularity of the cross-sectional shape of the pattern 3a of the organic underlayer film 3. Then, after sidewalls are formed by a sidewall spacer method using the organic underlayer film pattern 3a as a core material, that is, with the inorganic silicon-containing film 7, the organic underlayer film pattern 3a is removed to form the pattern 7a of the inorganic silicon-containing film 7. Unlike a case where a silicon-containing middle layer film is used as a middle layer film, the tin-containing middle layer film residue 4b left on the upper portion of the organic underlayer film pattern 3a can be easily removed by dry-etching without damaging the sidewalls formed of the inorganic silicon-containing film 7 or the substrate 10 to be processed, thereby eliminating the problems such as performance deterioration of products and yield decrease.

### EXAMPLES

Hereinafter, the present invention will be specifically described with reference to Examples and Comparative Examples. However, the present invention is not limited by the description thereof.

The molecular weight and the dispersity were measured by the following method. The weight average molecular weight (Mw) in terms of polystyrene and the dispersity (Mw/Mn) were determined by gel permeation chromatography (GPC) using tetrahydrofuran as an eluent.

### [Synthesis Examples]

In the following Synthesis Examples, the following compound group G: (G1) to (G14) and tin compound group S: (S1) to (S3) were used.

The compound group G: (G1) to (G14) is as follows.

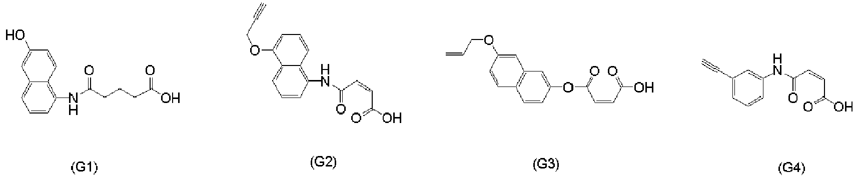

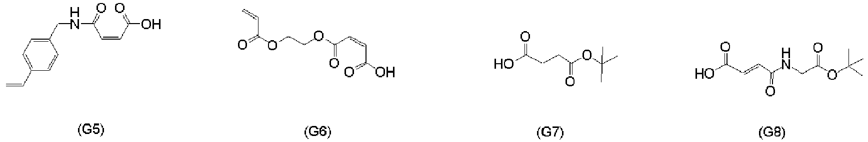

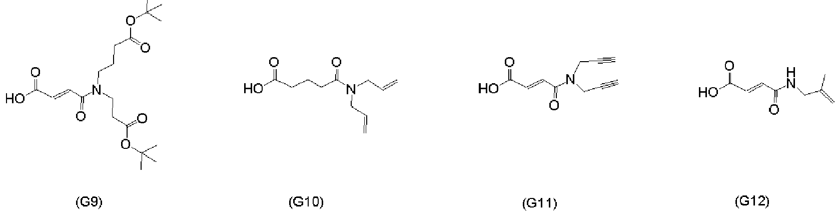

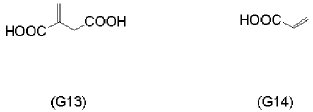

The tin compound group S: (S1) to (S3) is as follows.
(S1): dibutyltin oxide
(S2): dibenzyltin oxide
(S3): dioctyltin oxide

### [Synthesis Example 1] Synthesis of compound (A-1) for forming a tin-containing middle layer film

Dibutyltin oxide (S1) (5.0 g), carboxylic acid (G1) (11.0 g), and toluene (100 g) were charged and refluxed for seven hours while removing water. After the reaction, the solvent was removed under a reduced pressure, and with addition of hexane, filtration and washing were performed. The recovered solid was dried under vacuum at 70°C to yield a compound (A-1) for forming a tin-containing middle layer film.
(A-1): Mw = 254, Mw/Mn = 1.18

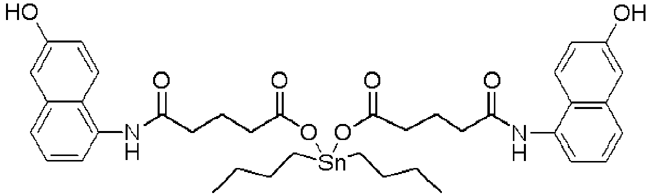

### [Synthesis Example 2] Synthesis of compounds (A-2) to (A-13) for forming a tin-containing middle layer film

Compounds (A-2) to (A-13) for forming a tin-containing middle layer film listed in Tables 1 and 2 were obtained under the same reaction conditions as in Synthesis Example 1 except that any one of the compounds in the above compound group G and any one of the compounds in the above tin compound group S were used in the amounts listed in Tables 1 and 2. The weight average molecular weight (Mw) and the dispersity (Mw/Mn) of these compounds were determined. The results are listed in Table 3.

**[Table 1]**

| Syn. Ex. | Tin compound group S | | Compound group G | | Compound for forming tin-containing middle layer film |
|---|---|---|---|---|---|
| | Compound | g | Compound | g | |
| 1 | S1 | 5.0 | G1 | 11.0 | 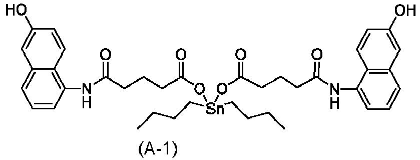 |
| 2 | S1 | 5.0 | G2 | 11.9 | 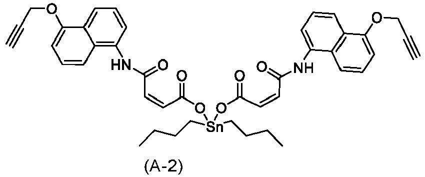 |
| 3 | S1 | 5.0 | G3 | 120 | 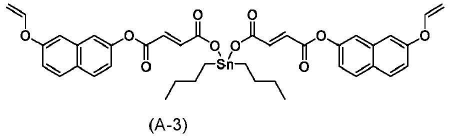 |
| 4 | S1 | 5.0 | G4 | 8.6 | 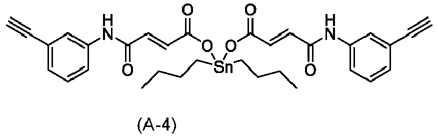 |
| 5 | S1 | 5.0 | G5 | 9.3 | 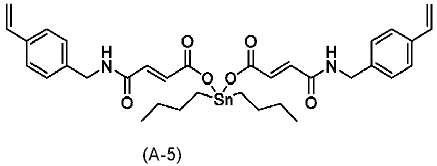 |
| 6 | S1 | 5.0 | G6 | 8.6 | 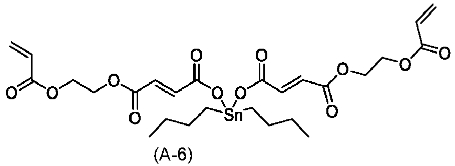 |
| 7 | S1 | 5.0 | G7 | 7.0 | 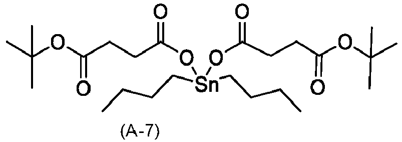 |

**[Table 2]**

| Syn. Ex. | Tin compound group S | | Compound group G | | Compound or polymer for forming tin-containing middle layer film |
|---|---|---|---|---|---|
| | Compound | g | Compound | g | |
| 8 | S1 | 5.0 | G8 | 9.2 | 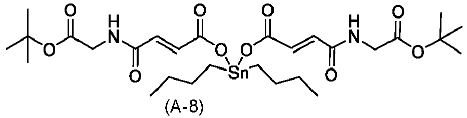 |
| 9 | S1 | 5.0 | G9 | 156 | 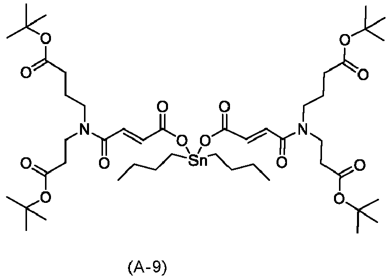 |
| 10 | S1 | 5.0 | G10 | 8.5 | 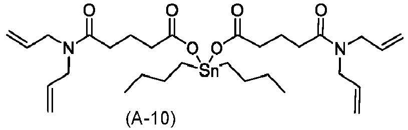 |
| 11 | S2 | 5.0 | G11 | 6.0 | 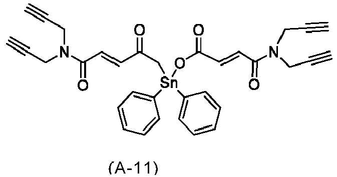 |
| 12 | S3 | 5.0 | G12 | 45 | 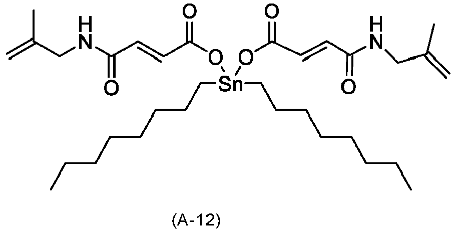 |
| 13 | S1 | 5.0 | G13/G14 | 3.9/ 14 | 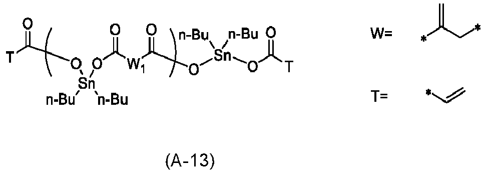 |

**[Table 3]**

| Synthesis Example | Compound or polymer for forming tin-containing middle layer film | Mw | Mw/Mn |
|---|---|---|---|
| 1 | (A-1) | 254 | 1.18 |
| 2 | (A-2) | 267 | 1.03 |
| 3 | (A-3) | 260 | 1.02 |
| 4 | (A-4) | 152 | 1.02 |
| 5 | (A-5) | 253 | 1.1 |
| 6 | (A-6) | 385 | 1.02 |
| 7 | (A-7) | 322 | 1.05 |
| 8 | (A-8) | 283 | 1.01 |
| 9 | (A-9) | 514 | 1.1 |
| 10 | (A-10) | 392 | 1.03 |
| 11 | (A-11) | 324 | 1.13 |
| 12 | (A-12) | 295 | 1.1 |
| 13 | (A-13) | 2741 | 1.88 |

### [Preparation of Composition (UDL-1) for Forming Tin-Containing Middle Layer Film]

A composition (UDL-1) for forming a tin-containing middle layer film was prepared by dissolving the compound (A-1) for forming a tin-containing middle layer film in a solvent mixture of propylene glycol monomethyl ether acetate (PGMEA) containing 0.5% by mass of a surfactant FC-4430 (manufactured by Sumitomo 3M Limited) and cyclohexanone (CyHO) in the proportions listed in Table 4, and filtering the solution through a 0.02 um membrane filter.

### [Preparation of Compositions (UDL-2 to UDL-13) for Forming Tin-Containing Middle Layer Film]

Each of compositions (UDL-2 to UDL-13) for forming a tin-containing middle layer film was prepared through the same operation as in UDL-1 except that the kinds and contents of components were as listed in Table 4.

**[Table 4]**

| Composition for forming tin-containing middle layer film | Compound or polymer for forming tin-containing middle layer film | Parts by mass | Solvent | Parts by mass |
|---|---|---|---|---|
| UDL-1 | (A-1) | 2 | PGMEA/CyHO (54/54) | 98 |
| UDL-2 | (A-2) | 2 | PGMEA/CyHO (54/54) | 98 |
| UDL-3 | (A-3) | 2 | PGMEA/CyHO (54/54) | 98 |
| UDL-4 | (A-4) | 2 | PGMEA/CyHO (54/54) | 98 |
| UDL-5 | (A-5) | 2 | PGMEA/CyHO (54/54) | 98 |
| UDL-6 | (A-6) | 2 | PGMEA/CyHO (54/54) | 98 |
| UDL-7 | (A-7) | 2 | PGMEA/CyHO (54/54) | 98 |
| UDL-8 | (A-8) | 2 | PGMEA/CyHO (54/54) | 98 |
| UDL-9 | (A-9) | 2 | PGMEA/CyHO (54/54) | 98 |
| UDL-10 | (A-10) | 2 | PGMEA/CyHO (54/54) | 98 |
| UDL-11 | (A-11) | 2 | PGMEA/CyHO (54/54) | 98 |
| UDL-12 | (A-12) | 2 | PGMEA/CyHO (54/54) | 98 |
| UDL-13 | (A-13) | 2 | PGMEA/CyHO (54/54) | 98 |

### <Patterning Process 1>

### [Examples 1-1 to 1-13]

ODL-306 manufactured by Shin-Etsu Chemical Co., Ltd. was used as an organic underlayer film on a substrate to be processed, applied on a Si wafer serving as the substrate to be processed by spin coating, and baked at 350°C for 60 seconds to fabricate a carbon film with a film thickness of 80 nm. The carbon proportion in the carbon film was 88%. One of the compositions (UDL-1 to UDL-13) for forming a tin-containing middle layer film listed in Table 6 below was used as a tin-containing middle layer film, applied on the organic underlayer film by spin coating, and baked at 250°C for 60 seconds to fabricate a tin-containing middle layer film with a film thickness of 20 nm.

Further, a composition for forming an upper layer resist film containing a polymer 1 having the following composition, an acid generator (PAG1), a basic compound (Quencher 1), and an organic solvent was applied on the tin-containing middle layer film by spin coating and baked at 110°C for 60 seconds to fabricate an upper layer resist film. The thickness of the upper layer resist film was 120 nm.
Polymer 1
Molecular weight (Mw) = 8,100
Dispersity (Mw/Mn) = 1.77

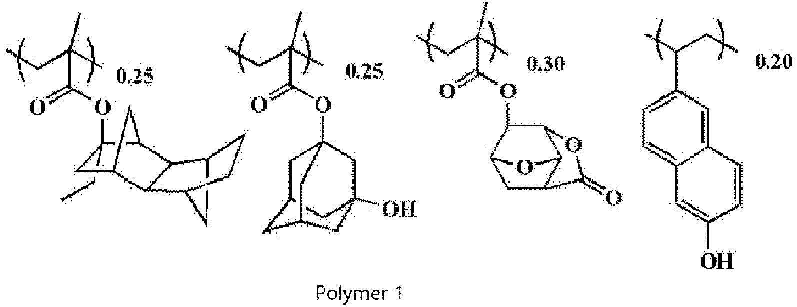

### Acid generator: PAG1

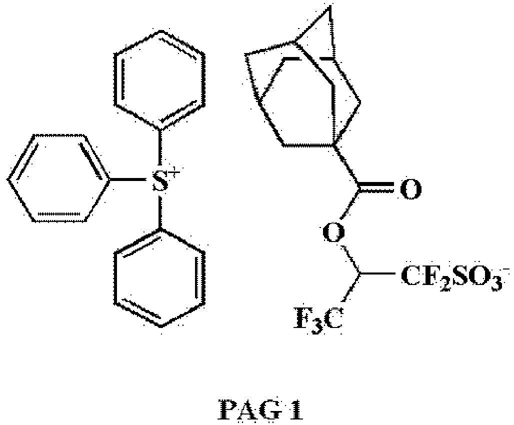

### Basic compound: Quencher 1

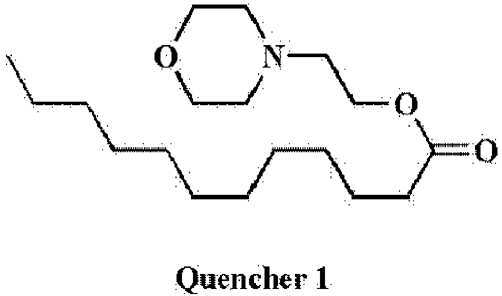

### Organic solvent: PGMEA (propylene glycol monomethyl ether acetate)

### CyH (cyclohexanone)

This was exposed by using an ArF excimer laser scanner (manufactured by Nikon Corporation, NSR-S307E, NA 0.85, σ 0.93/0.69, 20 degree dipole illumination, 6% halftone phase shift mask), baked at 100°C for 60 seconds immediately after exposure, and developed for 30 seconds with an aqueous solution of 2.38% by mass of tetramethylammonium hydroxide to obtain a positive isolated pattern (upper layer resist pattern) with a size of 50 nm and a pitch of 130 nm.

The tin-containing middle layer film was subjected to dry-etching under the following conditions (1) while using the upper layer resist pattern as a mask, and subsequently the pattern was transferred to the organic underlayer film under the following conditions (2). This was performed such that a portion of the tin-containing middle layer film was left on the organic underlayer film pattern.

### (1) Etching Conditions with H₂-Based Gas

Apparatus: dry-etching apparatus Telius SP manufactured by Tokyo Electron Limited
Etching conditions (1):
   Chamber pressure: 100 mT
   RF power (upper): 300 W
   RF power (lower): 500 W
   H₂ gas flow rate: 200 sccm
   CHF₃ gas flow rate: 30 sccm
   Process time: 20 sec

### (2) Etching Conditions with O₂-Based Gas

Apparatus: dry-etching apparatus Telius SP manufactured by Tokyo Electron Limited
Etching conditions (2):
   Chamber pressure: 10 mT
   RF power (upper): 1,000 W
   RF power (lower): 300 W
   CO₂ gas flow rate: 320 sccm
   N₂ gas flow rate: 80 sccm
   Time: 50 sec

The tin-containing middle layer film left on the resulting organic underlayer film pattern was removed by dry-etching under the following conditions (3).

### Etching conditions (3):

Chamber pressure: 100 mT
RF power (upper): 300 W
RF power (lower): 500 W
H₂ gas flow rate: 200 sccm
Ar gas flow rate: 100 sccm
Process time: 20 sec

Subsequently, a silicon oxide film (ALD film) with a thickness of 30 nm was formed on the resulting organic underlayer film pattern, using an ALD apparatus by the method described in Examples [0043] to [0053] in JP 2005-197561 A. Subsequently, the ALD film was dry-etched under the following conditions (4) to expose an upper portion of the organic underlayer film pattern, resulting in a test wafer with the core material (organic underlayer film pattern) exposed.

### (4) Etching Conditions with CHF₃/CF₄-Based Gas

Apparatus: dry-etching apparatus Telius SP manufactured by Tokyo Electron Limited
Etching conditions (4):
   Chamber pressure: 50 mT
   RF power (upper): 200 W
   RF power (lower): 100 W
   CHF₃ gas flow rate: 50 sccm
   CF₄ gas flow rate: 50 sccm
   Ar gas flow rate: 100 sccm
   Time: 20 sec

The resulting test wafer was dry-etched under the following conditions (5) to remove the organic underlayer film pattern, thereby forming an ALD film pattern (silicon-containing film pattern). Thereafter, the cross-sectional shape of the ALD film pattern and the substrate to be processed was observed with S-4700 manufactured by Hitachi High-Technologies Corporation.

### (5) Etching Conditions with O₂-Based Gas

Apparatus: dry-etching apparatus Telius SP manufactured by Tokyo Electron Limited
Etching conditions (5):
   Chamber pressure: 10 mT
   RF power (upper): 1,000 W
   RF power (lower): 300 W
   CO₂ gas flow rate: 320 sccm
   N₂ gas flow rate: 80 sccm
   Time: 50 sec

### [Comparative Example 1-1]

In Comparative Example 1-1, a silicon-containing middle layer film was used instead of a tin-containing middle layer film. Specifically, as the silicon-containing middle layer film, a silicon-containing middle layer film with a film thickness of 20 nm was fabricated by applying a silicon atom-containing resist middle layer film material (SOG-1) containing the following raw materials on the organic underlayer film by spin coating, and baking at 220°C for 60 seconds. In Comparative Example 1-1, pattern formation was performed by performing the same process as in Example 1-1, except that a silicon-containing middle layer film was used instead of a tin-containing middle layer film. The result is listed in Table 6 below.

As the silicon atom-containing resist middle layer film material (SOG-1), a silicon atom-containing resist middle layer material (SOG-1) was prepared by dissolving a polymer denoted as ArF silicon-containing middle layer film polymer (SiP1) and a crosslinking catalyst (CAT1) in propylene glycol monoethyl ether which is an organic solvent containing 0.1% by mass of FC-4430 (manufactured by Sumitomo 3M Limited) in the proportions listed in Table 5 and filtering the solution through a fluorocarbon resin filter with a pore diameter of 0.1 µm.

**[Table 5]**

| | Polymer | Thermal crosslinking catalyst | Organic solvent |
|---|---|---|---|
| | (Parts by mass) | (Parts by mass) | (Parts by mass) |
| SOG-1 | SiP1 (100) | CAT1 (1) | Propylene glycol monoethyl ether (4000) |

The structural formulae of the ArF silicon-containing middle layer film polymer (SiP1) and the crosslinking catalyst (CAT1) that were used are as follows.

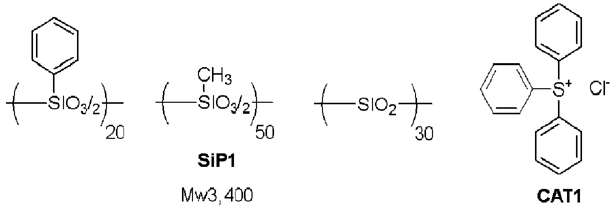

### [Comparative Example 1-2]

In Comparative Example 1-2, a silicon-containing middle layer film was used instead of a tin-containing middle layer film. Specifically, as the silicon-containing middle layer film, a silicon-containing middle layer film with a film thickness of 20 nm was fabricated by applying the same material as used in Comparative Example 1-1 on the organic underlayer film by spin coating and baking at 220°C for 60 seconds.

Further, an upper layer resist film similar to that of Example 1-1 was applied on the silicon-containing middle layer film by spin coating and baked at 110°C for 60 seconds to make a resist film with a thickness of 120 nm.

This was exposed using an ArF excimer laser scanner (manufactured by Nikon Corporation, NSR-S307E, N A 0.85, σ 0.93/0.69, 20 degree dipole illumination, 6% halftone phase shift mask), baked at 100°C for 60 seconds immediately after exposure, and developed for 30 seconds with an aqueous solution of 2.38% by mass of tetramethylammonium hydroxide to obtain a positive isolated pattern (upper layer resist pattern) with a size of 50 nm and a pitch of 130 nm.

The silicon-containing middle layer film was subjected to dry-etching under the following conditions (1') while using the upper layer resist pattern as a mask, and subsequently the pattern was transferred to the organic underlayer film under the following conditions (2'). This was performed such that a portion of the silicon-containing middle layer film was left on the organic underlayer film pattern.

### (1') Etching Conditions with CHF₃/CF₄-Based Gas

Apparatus: dry-etching apparatus Telius SP manufactured by Tokyo Electron Limited
Etching conditions (1'):
   Chamber pressure: 50 mT
   RF power (upper): 200 W
   RF power (lower): 100 W
   CHF₃ gas flow rate: 50 sccm
   CF₄ gas flow rate: 50 sccm
   Ar gas flow rate: 100 sccm
   Time: 20 sec

### (2') Etching Conditions with O₂-Based Gas

Apparatus: dry-etching apparatus Telius SP manufactured by Tokyo Electron Limited
Etching conditions (2'):
   Chamber pressure: 10 mT
   RF power (upper): 1,000 W
   RF power (lower): 300 W
   CO₂ gas flow rate: 320 sccm
   N₂ gas flow rate: 80 sccm
   Time: 50 sec

The silicon-containing middle layer film left on the resulting organic underlayer film pattern was dry-etched under the following conditions (3').

### Etching conditions (3'):

Chamber pressure: 50 mT
RF power (upper): 200 W
RF power (lower): 100 W
CHF₃ gas flow rate: 50 sccm
CF₄ gas flow rate: 50 sccm
Ar gas flow rate: 100 sccm
Time: 20 sec

Subsequently, a silicon oxide film (ALD film) with a thickness of 30 nm was formed on the resulting organic underlayer film pattern, by using an ALD apparatus and the method described in Examples [0043] to [0053] in JP 2005-197561 A. Subsequently, the ALD film was dry-etched under the following conditions (4') to expose an upper portion of the organic underlayer film pattern, resulting in a test wafer with the core material (organic underlayer film pattern) exposed.

### (4') Etching Conditions with CHF₃/CF₄-Based Gas

Apparatus: dry-etching apparatus Telius SP manufactured by Tokyo Electron Limited
Etching conditions (4'):
   Chamber pressure: 50 mT
   RF power (upper): 200 W
   RF power (lower): 100 W
   CHF₃ gas flow rate: 50 sccm
   CF₄ gas flow rate: 50 sccm
   Ar gas flow rate: 100 sccm
   Time: 20 sec

The resulting test wafer was dry-etched under the following conditions (5') to remove the organic underlayer film pattern, thereby forming an ALD film pattern (silicon-containing film pattern). Thereafter, the cross-sectional shape of the ALD film pattern and the substrate to be processed was observed with S-4700 manufactured by Hitachi High-Technologies Corporation.

### (5') Etching Conditions with O₂-Based Gas

Apparatus: dry-etching apparatus Telius SP manufactured by Tokyo Electron Limited
Etching conditions (5'):
   Chamber pressure: 10 mT
   RF power (upper): 1,000 W
   RF power (lower): 300 W
   CO₂ gas flow rate: 320 sccm
   N₂ gas flow rate: 80 sccm
   Time: 50 sec

The results of Examples 1-1 to 1-13, and Comparative Examples 1-1 and 1-2 are listed in Table 6 below.

**[Table 6]**

| Example | Middle layer film material | Bake temperature | Patterning Process 1 |
|---|---|---|---|
| | | °C | Sidewall pattern shape |
| Example 1-1 | UDL-1 | 250°C | Good |
| Example 1-2 | UDL-2 | 250°C | Good |
| Example 1-3 | UDL-3 | 250°C | Good |
| Example 1-4 | UDL-4 | 250°C | Good |
| Example 1-5 | UDL-5 | 250°C | Good |
| Example 1-6 | UDL-6 | 250°C | Good |
| Example 1-7 | UDL-7 | 250°C | Good |
| Example 1-8 | UDL-8 | 250°C | Good |
| Example 1-9 | UDL-9 | 250°C | Good |
| Example 1-10 | UDL-10 | 250°C | Good |
| Example 1-11 | UDL-11 | 250°C | Good |
| Example 1-12 | UDL-12 | 250°C | Good |
| Example 1-13 | UDL-13 | 250°C | Good |
| Comparative Example 1-1 | SOG-1 | 220°C | Fail to form |
| Comparative Example 1-2 | SOG-1 | 220°C | Poor |

In Examples 1-1 to 1-13, the sidewall (ALD film) pattern after removal of the core material had a favorable vertical shape, and damage to the sidewall pattern and the substrate was not found, suggesting that the patterning process in the present invention was useful for forming a fine pattern. The pitch of the sidewall pattern of 65 nm was achieved, which was 1/2 of the pitch of the upper layer resist pattern. On the other hand, in Comparative Example 1-1 in which the same process as in Example 1-1 was performed by using a silicon-containing middle layer film instead of a tin-containing middle layer film, since, unlike the tin-containing middle layer film, the silicon-containing middle layer film does not have selectivity to a H₂-based gas, the organic underlayer film pattern as the core material failed to be removed, and an inorganic silicon film pattern (sidewall pattern) with a pattern pitch that is 1/2 of that of the upper layer resist pattern failed to be formed. In Comparative Example 1-2 in which a silicon-containing middle layer film was used instead of a tin-containing middle layer film and dry-etching including a CF₄-based gas was used for removing the silicon-containing middle layer film, damage to the substrate was found, and the shape of the sidewall pattern after removal of the core material lacked smoothness. This is presumably because the shape of the organic underlayer film pattern was changed when the silicon-containing middle layer film left on the organic underlayer film pattern serving as the core material was removed by dry-etching. Presumably, the exposed substrate to be processed was etched and damaged at the same time.

### <Patterning Process 2>

### [Examples 2-1 to 2-13]

ODL-306 manufactured by Shin-Etsu Chemical Co., Ltd. was used as an organic underlayer film on a substrate to be processed, applied on a Si wafer serving as the substrate to be processed by spin coating, and baked at 350°C for 60 seconds to fabricate a carbon film with a film thickness of 80 nm. The carbon proportion in the carbon film was 88%. One of the compositions (UDL-1 to UDL-13) for forming a tin-containing middle layer film listed in Table 7 below was used as a tin-containing middle layer film, applied on the organic underlayer film by spin coating, and baked at 250°C for 60 seconds to fabricate a tin-containing middle layer film with a film thickness of 20 nm.

Further, an upper layer resist film having a composition similar to that of Example 1-1 was applied on the silicon-containing middle layer film by spin coating and baked at 110°C for 60 seconds to make a resist film with a thickness of 120 nm.

This was exposed by using an ArF excimer laser scanner (manufactured by Nikon Corporation, NSR-S307E, N A 0.85, σ 0.93/0.69, 20 degree dipole illumination, 6% halftone phase shift mask), baked at 100°C for 60 seconds immediately after exposure, and developed for 30 seconds with an aqueous solution of 2.38% by mass of tetramethylammonium hydroxide to obtain a positive isolated pattern (upper layer resist pattern) with a size of 50 nm and a pitch of 130 nm.

The tin-containing middle layer film was subjected to dry-etching under the following conditions (6) using the upper layer resist pattern as a mask, and subsequently the pattern was transferred to the organic underlayer film under the following conditions (7). This was performed such that a portion of the tin-containing middle layer film was left on the organic underlayer film pattern.

### (6) Etching Conditions with H₂-Based Gas

Apparatus: dry-etching apparatus Telius SP manufactured by Tokyo Electron Limited
Etching conditions (6):
   Chamber pressure: 100 mT
   RF power (upper): 300 W
   RF power (lower): 500 W
   H₂ gas flow rate: 200 sccm
   CHF₃ gas flow rate: 30 sccm
   Process time: 20 sec

### (7) Etching Conditions with O₂-Based Gas

Apparatus: dry-etching apparatus Telius SP manufactured by Tokyo Electron Limited
Etching conditions (7):
   Chamber pressure: 10 mT
   RF power (upper): 1,000 W
   RF power (lower): 300 W
   CO₂ gas flow rate: 320 sccm
   N₂ gas flow rate: 80 sccm
   Time: 50 sec

A silicon oxide film (ALD film) with a thickness of 30 nm was formed on the resulting organic underlayer film pattern and a portion of the tin-containing middle layer film, by using an ALD apparatus and the method described in Examples [0043] to [0053] in JP 2005-197561 A. Subsequently, the ALD film was dry-etched under the following conditions (8) to expose an upper portion of a portion of the tin-containing middle layer film, resulting in a test wafer with a portion of the tin-containing middle layer film exposed.

### (8) Etching Conditions with CHF₃/CF₄-Based Gas

Apparatus: dry-etching apparatus Telius SP manufactured by Tokyo Electron Limited
Etching conditions (8):
   Chamber pressure: 50 mT
   RF power (upper): 200 W
   RF power (lower): 100 W
   CHF₃ gas flow rate: 50 sccm
   CF₄ gas flow rate: 50 sccm
   Ar gas flow rate: 100 sccm
   Time: 20 sec

The resulting test wafer was dry-etched under the following conditions (9) to remove the tin-containing middle layer film on the organic underlayer film pattern. Subsequently, dry-etching was performed under the following conditions (10) to remove the organic underlayer film pattern, thereby forming an ALD film pattern (silicon-containing film pattern). The cross-sectional shape of the ALD film pattern and the substrate to be processed was observed with S-4700 manufactured by Hitachi High-Technologies Corporation. As a result, damage to the sidewall pattern and the substrate to be processed during removal of the core material (organic underlayer film pattern) was not found. The results are collectively listed in Table 7 below.

### (9) Etching Conditions with H₂-Based Gas

Apparatus: dry-etching apparatus Telius SP manufactured by Tokyo Electron Limited
Etching conditions (9):
   Chamber pressure: 100 mT
   RF power (upper): 300 W
   RF power (lower): 500 W
   H₂ gas flow rate: 200 sccm
   Ar gas flow rate: 100 sccm
   Process time: 20 sec

### (10) Etching Conditions with O₂-Based Gas

Apparatus: dry-etching apparatus Telius SP manufactured by Tokyo Electron Limited
Etching conditions (10):
   Chamber pressure: 10 mT
   RF power (upper): 1,000 W
   RF power (lower): 300 W
   CO₂ gas flow rate: 320 sccm
   N₂ gas flow rate: 80 sccm
   Time: 50 sec

### [Comparative Example 2-1]

In Comparative Example 2-1, a silicon-containing middle layer film was used instead of a tin-containing middle layer film. Specifically, as the silicon-containing middle layer film, a silicon-containing middle layer film with a film thickness of 20 nm was fabricated by applying the following silicon atom-containing resist middle layer film material (SOG-1) on the organic underlayer film by spin coating and baking at 220°C for 60 seconds. In Comparative Example 2-1, pattern formation was performed by performing the same process as in Example 2-1, except that a silicon-containing middle layer film was used instead of a tin-containing middle layer film.

A silicon atom-containing resist middle layer material (SOG-1) similar to that of Comparative Example 1-1 was used as the silicon atom-containing resist middle layer film material (SOG-1).

### [Comparative Example 2-2]

In Comparative Example 2-2, a silicon-containing middle layer film was used instead of a tin-containing middle layer film. Specifically, as the silicon-containing middle layer film, a silicon-containing middle layer film with a film thickness of 20 nm was fabricated by applying the same material as used in Comparative Example 2-1 on the organic underlayer film by spin coating and baking at 220°C for 60 seconds.

Further, an upper layer resist film similar to that of Example 2-1 was applied on the silicon-containing middle layer film by spin coating and baked at 110°C for 60 seconds to make a resist film with a thickness of 120 nm.

This was exposed by using an ArF excimer laser scanner (manufactured by Nikon Corporation, NSR-S307E, N A 0.85, σ 0.93/0.69, 20 degree dipole illumination, 6% halftone phase shift mask), baked at 100°C for 60 seconds immediately after exposure, and developed for 30 seconds with an aqueous solution of 2.38% by mass of tetramethylammonium hydroxide to obtain a positive isolated pattern (upper layer resist pattern) with a size of 50 nm and a pitch of 130 nm.

The silicon-containing middle layer film was subjected to dry-etching under the following conditions (6') while using the resist pattern as a mask, and subsequently the pattern was transferred to the organic underlayer film under the following conditions (7'). This was performed such that a portion of the silicon-containing middle layer film was left on the organic underlayer film pattern.

### (6') Etching Conditions with CHF₃/CF₄-Based Gas

Apparatus: dry-etching apparatus Telius SP manufactured by Tokyo Electron Limited
Etching conditions (6'):
   Chamber pressure: 50 mT
   RF power (upper): 200 W
   RF power (lower): 100 W
   CHF₃ gas flow rate: 50 sccm
   CF₄ gas flow rate: 50 sccm
   Ar gas flow rate: 100 sccm
   Time: 20 sec

### (7') Etching Conditions with O₂-Based Gas

Apparatus: dry-etching apparatus Telius SP manufactured by Tokyo Electron Limited
Etching conditions (7'):
   Chamber pressure: 10 mT
   RF power (upper): 1,000 W
   RF power (lower): 300 W
   CO₂ gas flow rate: 320 sccm
   N₂ gas flow rate: 80 sccm
   Time: 50 sec

A silicon oxide film (ALD film) with a thickness of 30 nm was formed on the resulting organic underlayer film pattern and a portion of the silicon-containing middle layer film, using an ALD apparatus by the method described in Examples [0043] to [0053] in JP 2005-197561 A. Subsequently, the ALD film was dry-etched under the following conditions (8') to expose an upper portion of a portion of the silicon-containing middle layer film, resulting in a test wafer with a portion of the silicon-containing middle layer film exposed.

### (8') Etching Conditions with CHF₃/CF₄-Based Gas

Apparatus: dry-etching apparatus Telius SP manufactured by Tokyo Electron Limited
Etching conditions (8'):
   Chamber pressure: 50 mT
   RF power (upper): 200 W
   RF power (lower): 100 W
   CHF₃ gas flow rate: 50 sccm
   CF₄ gas flow rate: 50 sccm
   Ar gas flow rate: 100 sccm
   Time: 20 sec

The resulting test wafer was dry-etched under the following conditions (9') to remove the silicon-containing middle layer film on the organic underlayer film pattern. Subsequently, dry-etching was performed under the following conditions (10') to remove the organic underlayer film, thereby forming an ALD film pattern (silicon-containing film pattern). Thereafter, the cross-sectional shape of the ALD film pattern and the substrate to be processed was observed with S-4700 manufactured by Hitachi High-Technologies Corporation. As a result, damage to the sidewall pattern and the substrate during removal of the core material was found.

### (9') Etching Conditions with CHF₃/CF₄-Based Gas

Apparatus: dry-etching apparatus Telius SP manufactured by Tokyo Electron Limited
Etching conditions (9'):
   Chamber pressure: 50 mT
   RF power (upper): 200 W
   RF power (lower): 100 W
   CHF₃ gas flow rate: 50 sccm
   CF₄ gas flow rate: 50 sccm
   Ar gas flow rate: 100 sccm
   Time: 20 sec

### (10') Etching Conditions with O₂-Based Gas

Apparatus: dry-etching apparatus Telius SP manufactured by Tokyo Electron Limited
Etching conditions (10'):
   Chamber pressure: 10 mT
   RF power (upper): 1,000 W
   RF power (lower): 300 W
   CO₂ gas flow rate: 320 sccm
   N₂ gas flow rate: 80 sccm
   Time: 50 sec

**[Table 7]**

| Example | Middle layer film material | Bake temperature | Patterning Process 2 |
|---|---|---|---|
| | | °C | Sidewall pattern shape |
| Example 2-1 | UDL-1 | 250°C | Good |
| Example 2-2 | UDL-2 | 250°C | Good |
| Example 2-3 | UDL-3 | 250°C | Good |
| Example 2-4 | UDL-4 | 250°C | Good |
| Example 2-5 | UDL-5 | 250°C | Good |
| Example 2-6 | UDL-6 | 250°C | Good |
| Example 2-7 | UDL-7 | 250°C | Good |
| Example 2-8 | UDL-8 | 250°C | Good |
| Example 2-9 | UDL-9 | 250°C | Good |
| Example 2-10 | UDL-10 | 250°C | Good |
| Example 2-11 | UDL-11 | 250°C | Good |
| Example 2-12 | UDL-12 | 250°C | Good |
| Example 2-13 | UDL-13 | 250°C | Good |
| Comparative Example 2-1 | SOG-1 | 220°C | Fail to form |
| Comparative Example 2-2 | SOG-1 | 220°C | Poor |

In Examples 2-1 to 2-13, the sidewall (ALD film) pattern after removal of the core material had a favorable vertical shape, and damage to the sidewall pattern and the substrate was not found, suggesting that the patterning process in the present invention was useful for forming a fine pattern. The pitch of the sidewall pattern of 65 nm was achieved, which was 1/2 of the pitch of the upper layer resist pattern. On the other hand, in Comparative Example 2-1 in which the same process as in Example 2-1 was performed by using a silicon-containing middle layer film instead of a tin-containing middle layer film, since, unlike the tin-containing middle layer film, the silicon-containing middle layer film does not have selectivity to a H₂-based gas, the organic underlayer film pattern as the core material failed to be removed, and an inorganic silicon film pattern (sidewall pattern) with a pattern pitch that is 1/2 of that of the upper layer resist pattern failed to be formed. In Comparative Example 2-2 in which a silicon-containing middle layer film was used instead of a tin-containing middle layer film and dry-etching including a CF₄-based gas was used for removing the silicon-containing middle layer film, damage to the substrate was found, and the shape of the sidewall pattern after removal of the core material lacked smoothness. This is presumably because the shape of the organic underlayer film pattern was changed when the silicon-containing middle layer film left on the organic underlayer film pattern serving as the core material was removed by dry-etching. Presumably, the exposed substrate to be processed was etched and damaged at the same time.

Based on the foregoing, with the fine patterning process using a sidewall spacer process according to the present invention, the organic underlayer film pattern forming the core material, or the organic underlayer film pattern and a portion of the tin-containing middle layer film can be removed by dry-etching without damaging the inorganic silicon-containing film that forms sidewalls or the substrate to be processed. Thus, a practical patterning process can be provided that can readily and efficiently form an inorganic silicon-containing film pattern (sidewall pattern) with a pattern pitch that is 1/2 of that of the upper layer resist pattern without causing unsatisfactory performance of products or yield decrease.

The present invention includes the following embodiments.
[1] A patterning process for forming a pattern in a substrate to be processed, the method comprising steps of:
   (i-1) forming an organic underlayer film on a substrate to be processed, forming a tin-containing middle layer film on the organic underlayer film, and further forming an upper layer resist film on the tin-containing middle layer film;
   (i-2) performing pattern exposure and subsequent development in the upper layer resist film to form an upper layer resist pattern;
   (i-3) dry-etching the tin-containing middle layer film while using the upper layer resist pattern as a mask to transfer the upper layer resist pattern to the tin-containing middle layer film, and further dry-etching the organic underlayer film while using the tin-containing middle layer film having the transferred upper layer resist pattern as a mask to form an organic underlayer film pattern on an upper portion of which a portion of the tin-containing middle layer film is left;
   (i-4) removing the portion of the tin-containing middle layer film left on the upper portion of the organic underlayer film pattern by dry-etching;
   (i-5) forming an inorganic silicon-containing film comprising polysilicon, amorphous silicon, silicon oxide, silicon nitride, silicon oxynitride, silicon carbide, or a composite material thereof, by a CVD method or an ALD method, so as to cover the organic underlayer film pattern;
   (i-6) removing a portion of the inorganic silicon-containing film by dry-etching to expose the upper portion of the organic underlayer film pattern;
   (i-7) removing the organic underlayer film pattern to form an inorganic silicon-containing film pattern with a pattern pitch that is 1/2 of a pattern pitch of the upper layer resist pattern; and
   (i-8) processing the substrate to be processed while using the inorganic silicon-containing film pattern as a mask to form a pattern in the substrate to be processed.
[2] A patterning process for forming a pattern in a substrate to be processed, the method comprising steps of:
   (ii-1) forming an organic underlayer film on a substrate to be processed, forming a tin-containing middle layer film on the organic underlayer film, and further forming an upper layer resist film on the tin-containing middle layer film;
   (ii-2) performing pattern exposure and subsequent development in the upper layer resist film to form an upper layer resist pattern;
   (ii-3) dry-etching the tin-containing middle layer film while using the upper layer resist pattern as a mask to transfer the upper layer resist pattern to the tin-containing middle layer film, and further dry-etching the organic underlayer film while using the tin-containing middle layer film having the transferred upper layer resist pattern as a mask to form an organic underlayer film pattern on an upper portion of which a portion of the tin-containing middle layer film is left;
   (ii-4) forming an inorganic silicon-containing film comprising polysilicon, amorphous silicon, silicon oxide, silicon nitride, silicon oxynitride, silicon carbide, or a composite material thereof, by a CVD method or an ALD method, so as to cover the portion of the tin-containing middle layer film and the organic underlayer film pattern;
   (ii-5) removing a portion of the inorganic silicon-containing film by dry-etching to expose an upper portion of the portion of the tin-containing middle layer film;
   (ii-6) removing the portion of the tin-containing middle layer film left on the upper portion of the organic underlayer film pattern by dry-etching;
   (ii-7) removing the organic underlayer film pattern by dry-etching to form an inorganic silicon-containing film pattern with a pattern pitch that is 1/2 of a pattern pitch of the upper layer resist pattern;
      and
   (ii-8) processing the substrate to be processed while using the inorganic silicon-containing film pattern as a mask to form a pattern in the substrate to be processed.
[3] The patterning process according to [1] or [2], wherein in the step (i-4) or (ii-6), the tin-containing middle layer film is etched by plasma formed in a H₂-containing gas.
[4] The patterning process according to any one of [1] to [3], wherein the tin-containing middle layer film is formed by spin coating using a composition for forming a tin-containing middle layer film.
[5] The patterning process according to any one of [1] to [4], wherein the tin-containing middle layer film is formed from a composition for forming a tin-containing middle layer film, the composition comprising a compound having a crosslinkable organic structure.
[6] The patterning process according to [5], wherein the compound having one or more selected from the group consisting of:
   a hydroxyl group;
   an organic group having a protective group which is to be eliminated by an action of acid or heat or both to generate one or more hydroxyl groups or carboxyl groups; and
   an organic group represented by any one of the following general formulae (a-1) to (a-3) and (b-1) to (b-4)
      is used as the crosslinkable organic structure: 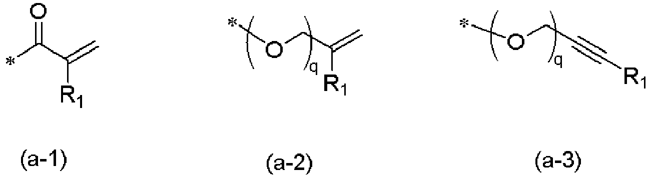 (in the general formulae (a-1) to (a-3), R₁ represents a hydrogen atom or a monovalent organic group having 1 to 10 carbon atoms, q represents 0 or 1, and * represents a bonding point) 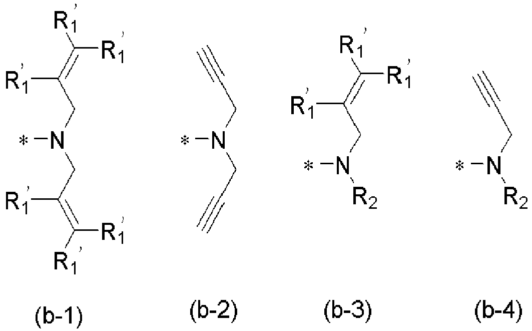 (in the general formulae (b-1) and (b-3), R₁' represents a hydrogen atom or a methyl group, and in the same formula, they may be the same or different; in (b-3) to (b-4), R₂ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms; * represents a bonding point).
[7] The patterning process according to any one of [1] to [6], wherein in the step (i-1) or (ii-1), a water-repellent coating film is further formed on the upper layer resist film.
[8] The patterning process according to any one of [1] to [7], wherein in the step (i-1) or (ii-1), an organic adhesive film is formed in middle between the tin-containing middle layer film and the upper layer resist film.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A patterning process for forming a pattern in a substrate to be processed, the method comprising steps of:
(i-1) forming an organic underlayer film on a substrate to be processed, forming a tin-containing middle layer film on the organic underlayer film, and further forming an upper layer resist film on the tin-containing middle layer film;
(i-2) performing pattern exposure and subsequent development in the upper layer resist film to form an upper layer resist pattern;
(i-3) dry-etching the tin-containing middle layer film while using the upper layer resist pattern as a mask to transfer the upper layer resist pattern to the tin-containing middle layer film, and further dry-etching the organic underlayer film while using the tin-containing middle layer film having the transferred upper layer resist pattern as a mask to form an organic underlayer film pattern on an upper portion of which a portion of the tin-containing middle layer film is left;
(i-4) removing the portion of the tin-containing middle layer film left on the upper portion of the organic underlayer film pattern by dry-etching;
(i-5) forming an inorganic silicon-containing film comprising polysilicon, amorphous silicon, silicon oxide, silicon nitride, silicon oxynitride, silicon carbide, or a composite material thereof, by a CVD method or an ALD method, so as to cover the organic underlayer film pattern;
(i-6) removing a portion of the inorganic silicon-containing film by dry-etching to expose the upper portion of the organic underlayer film pattern;
(i-7) removing the organic underlayer film pattern to form an inorganic silicon-containing film pattern with a pattern pitch that is 1/2 of a pattern pitch of the upper layer resist pattern; and
(i-8) processing the substrate to be processed while using the inorganic silicon-containing film pattern as a mask to form a pattern in the substrate to be processed; or
a patterning process for forming a pattern in a substrate to be processed, the method comprising steps of:
(ii-1) forming an organic underlayer film on a substrate to be processed, forming a tin-containing middle layer film on the organic underlayer film, and further forming an upper layer resist film on the tin-containing middle layer film;
(ii-2) performing pattern exposure and subsequent development in the upper layer resist film to form an upper layer resist pattern;
(ii-3) dry-etching the tin-containing middle layer film while using the upper layer resist pattern as a mask to transfer the upper layer resist pattern to the tin-containing middle layer film, and further dry-etching the organic underlayer film while using the tin-containing middle layer film having the transferred upper layer resist pattern as a mask to form an organic underlayer film pattern on an upper portion of which a portion of the tin-containing middle layer film is left;
(ii-4) forming an inorganic silicon-containing film comprising polysilicon, amorphous silicon, silicon oxide, silicon nitride, silicon oxynitride, silicon carbide, or a composite material thereof, by a CVD method or an ALD method, so as to cover the portion of the tin-containing middle layer film and the organic underlayer film pattern;
(ii-5) removing a portion of the inorganic silicon-containing film by dry-etching to expose an upper portion of the portion of the tin-containing middle layer film;
(ii-6) removing the portion of the tin-containing middle layer film left on the upper portion of the organic underlayer film pattern by dry-etching;
(ii-7) removing the organic underlayer film pattern by dry-etching to form an inorganic silicon-containing film pattern with a pattern pitch that is 1/2 of a pattern pitch of the upper layer resist pattern;
and
(ii-8) processing the substrate to be processed while using the inorganic silicon-containing film pattern as a mask to form a pattern in the substrate to be processed.

2. The patterning process according to claim 1, wherein in the step (i-4) or (ii-6), the tin-containing middle layer film is etched by plasma formed in a H₂-containing gas.

3. The patterning process according to claim 1 or 2, wherein the tin-containing middle layer film is formed by spin coating using a composition for forming a tin-containing middle layer film.

4. The patterning process according to any one of claims 1 to 3, wherein the tin-containing middle layer film is formed from a composition for forming a tin-containing middle layer film, the composition comprising a compound having a crosslinkable organic structure.

5. The patterning process according to claim 4, wherein the compound having one or more selected from the group consisting of:
a hydroxyl group;
an organic group having a protective group which is to be eliminated by an action of acid or heat or both to generate one or more hydroxyl groups or carboxyl groups; and
an organic group represented by any one of the following general formulae (a-1) to (a-3) and (b-1) to (b-4)
is used as the crosslinkable organic structure: 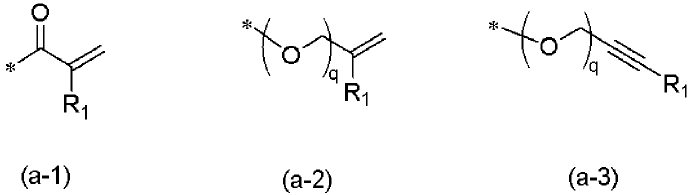
(in the general formulae (a-1) to (a-3), R₁ represents a hydrogen atom or a monovalent organic group having 1 to 10 carbon atoms, q represents 0 or 1, and * represents a bonding point) 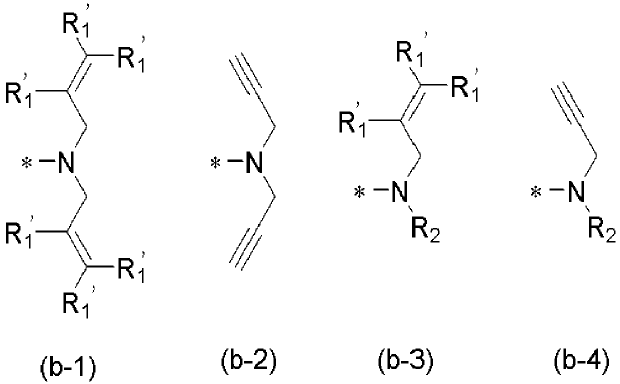
(in the general formulae (b-1) and (b-3), R₁' represents a hydrogen atom or a methyl group, and in the same formula, they may be the same or different; in (b-3) to (b-4), R₂ represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms; * represents a bonding point).

6. The patterning process according to any one of claims 1 to 5, wherein in the step (i-1) or (ii-1), a water-repellent coating film is further formed on the upper layer resist film.

7. The patterning process according to any one of claims 1 to 6, wherein in the step (i-1) or (ii-1), an organic adhesive film is formed in middle between the tin-containing middle layer film and the upper layer resist film.
